# EUROPEAN PATENT APPLICATION

(11) **EP 4 525 327 A1**
(43) Date of publication of application: **19.03.2025**
(21) Application number: 23822929.8
(22) Date of filing: 31.05.2023
(51) Int. Cl.: H04B 10/40

(54) **OPTICAL MODULE, RELATED APPARATUS, AND ASSEMBLING METHOD**

(30) Priority: 15.06.2022 CN 202210675108
(71) Applicant: Huawei Technologies Co., Ltd., Shenzhen, Guangdong 518129 (CN)
(72) Inventor: LIU, Wei, Shenzhen, Guangdong 518129 (CN); CHEN, Liuyong, Shenzhen, Guangdong 518129 (CN); SU, Changzheng, Shenzhen, Guangdong 518129 (CN); YU, Fei, Shenzhen, Guangdong 518129 (CN)
(74) Representative: Goddar, Heinz J.
(86) International application number: PCT/CN2023/097406
(87) International publication number: WO 2023/241359

(57) **Abstract**

Embodiments of the present invention disclose an optical module, a related apparatus, and an assembly method, to implement flexible combination of structures in an optical module, and effectively ensure that a transmitter optical subassembly and a receiver optical subassembly can match an optical module with an increased quantity of channels. An embodiment of the present invention provides an optical module. The optical module includes a first circuit board, a second circuit board, and a connection board. The first circuit board includes a transmitter optical subassembly and a receiver optical subassembly. The second circuit board includes a processing unit. The first circuit board further includes a first connection port. The second circuit board further includes a second connection port. The transmitter optical subassembly and the receiver optical subassembly are separately connected to the first connection port. The processing unit is connected to the second connection port. The first circuit board and the second circuit board are fastened to the connection board. The connection board is configured to align the first connection port with the second connection port. The first connection port and the second connection port are connected by using leads.

## Description

This application claims priority to Chinese Patent Application No. 202210675108.5, filed with the China National Intellectual Property Administration on June 15, 2022 and entitled "OPTICAL MODULE, RELATED APPARATUS, AND ASSEMBLY METHOD", which is incorporated herein by reference in its entirety.

### TECHNICAL FIELD

This application relates to the field of optical communication, and in particular, to an optical module, a related apparatus, and an assembly method.

### BACKGROUND

With continuous development of communication technologies, a capacity of information transmitted in communication is increasingly large, and an optical communication system can effectively increase the capacity of transmitted information. The optical communication system includes a network device and an optical module connected to the network device. The optical module is further connected to an optical cable. A receiver optical subassembly included in the optical module is configured to perform optical-to-electrical conversion on an optical signal from the optical cable, to send a converted electrical signal to the network device. A transmitter optical subassembly included in the optical module is configured to perform electrical-to-optical conversion on an electrical signal from the network device, to send a converted optical signal to the optical cable.

The optical module includes a printed circuit board assembly (printed circuit board assembly, PCBA). The PCBA may include an optical digital signal processor (optical digital signal processor, oDSP) configured to perform electrical signal processing, a driver (Driver, DRV), a transimpedance amplifier (transimpedance amplifier, TIA), a microcontroller unit (microcontroller unit, MCU), and the like. The transmitter optical subassembly and the receiver optical subassembly included in the optical module are packaged on the PCBA in a manner of chip-on-board (chip-on-board, COB) packaging.

However, the transmitter optical subassembly and the receiver optical subassembly are directly packaged on the PCBA, resulting in a fixed structure between the transmitter optical subassembly and the PCBA and between the receiver optical subassembly and the PCBA. In this case, the transmitter optical subassembly and the receiver optical subassembly cannot be flexibly combined with the PCBA, and a structure of the optical module is limited. In addition, with a requirement for an increased quantity of channels supported by the optical module, the transmitter optical subassembly and the receiver optical subassembly cannot match an optical module with an increased quantity of channels.

### SUMMARY

Embodiments of the present invention provide an optical module, a related apparatus, and an assembly method, to implement flexible combination of structures in an optical module, and effectively ensure that a transmitter optical subassembly and a receiver optical subassembly can match an optical module with an increased quantity of channels.

According to a first aspect of embodiments of the present invention, an optical module is provided. The optical module includes a first circuit board, a second circuit board, and a connection board. The first circuit board includes a transmitter optical subassembly and a receiver optical subassembly. The second circuit board includes a processing unit. The first circuit board further includes a first connection port. The second circuit board further includes a second connection port. The transmitter optical subassembly and the receiver optical subassembly are separately connected to the first connection port. The processing unit is connected to the second connection port. The first circuit board and the second circuit board are fastened to the connection board. The connection board is configured to align the first connection port with the second connection port. The first connection port and the second connection port are connected by using leads.

According to the optical module shown in this aspect, the first connection port is aligned with the second connection port by using the connection board. This ensures a successful connection between the first connection port and the second connection port by using the leads, and reduces a thread length of the lead connected between the first connection port and the second connection port. A reduction in the thread length reduces attenuation of an electrical signal transmitted between the first connection port and the second connection port, improves signal quality of the electrical signal, improves transmission efficiency of the transmitted electrical signal, and effectively ensures that the transmitter optical subassembly and the receiver optical subassembly can match an optical module with an increased quantity of channels.

Based on the first aspect, in an optional implementation, that the connection board is configured to align the first connection port with the second connection port includes: The first connection port includes a first high-speed interface, the second connection port includes a second high-speed interface, the first high-speed interface is any high-speed interface included in the first connection port, the second high-speed interface is a high-speed interface included in the second connection port, and the connection board is configured to align the first high-speed interface with the second high-speed interface; and the first connection port includes a first low-speed interface, the second connection port includes a second low-speed interface, the first low-speed interface is any low-speed interface included in the first connection port, the second low-speed interface is a low-speed interface included in the second connection port, and the connection board is configured to align the first low-speed interface with the second low-speed interface.

According to the optical module shown in this implementation, the first high-speed interface is aligned with the second high-speed interface by using the connection board, and the first low-speed interface is aligned with the second low-speed interface by using the connection board. This ensures a successful connection between the first connection port and the second connection port by using a lead and connection efficiency, reduces a thread of the lead, and improves manufacturing efficiency of the optical module.

Based on the first aspect, in an optional implementation, the leads include a first lead and a second lead, and that the first connection port and the second connection port are connected by using leads includes: The first high-speed interface and the second high-speed interface are connected by using the first lead, and the first low-speed interface and the second low-speed interface are connected by using the second lead.

According to the optical module shown in this implementation, the aligned first high-speed interface and the aligned second high-speed interface are connected by using the first lead, and the aligned first low-speed interface and the aligned second low-speed interface are connected by using the second lead, to reduce threads of the first lead and the second lead.

Based on the first aspect, in an optional implementation, an electrical signal transmission rate supported by the first lead is greater than an electrical signal transmission rate supported by the second lead.

According to the optical module shown in this implementation, the first lead is different from the second lead, and attenuation of an electrical signal in the second lead is greater than attenuation of the electrical signal in the first lead. Therefore, a transmission rate of the electrical signal in the second lead is less than a transmission rate of the electrical signal in the first lead. The second lead is used for an electrical signal with a low transmission rate, and the second lead does not need to support transmission of a high-speed electrical signal at high costs. This effectively reduces costs of the second lead, and further reduces overall costs of the optical module.

Based on the first aspect, in an optional implementation, in the first connection port, the first low-speed interface is located between two adjacent first high-speed interfaces, and in the second connection port, the second low-speed interface is located between two adjacent second high-speed interfaces.

According to the optical module shown in this implementation, a rate of an electrical signal transmitted by the first high-speed interface is greater than a rate of an electrical signal transmitted by the first low-speed interface. Therefore, when the first low-speed interface is located between two adjacent first high-speed interfaces, the first low-speed interface can perform a block function to some extent, to reduce crosstalk between electrical signals respectively transmitted by the two first high-speed interfaces.

Based on the first aspect, in an optional implementation, the first high-speed interface includes a first pin and a second pin, the first pin is connected to the transmitter optical subassembly, and the second pin is grounded; the second high-speed interface includes a third pin and a fourth pin, the third pin is separately connected to the first pin and the processing unit, and the fourth pin is separately connected to the second pin and the processing unit; and the third pin is configured to receive a first electrical signal from the processing unit, and the fourth pin is configured to receive a second electrical signal from the processing unit, where the first electrical signal and the second electrical signal are a pair of differential electrical signals.

According to the optical module shown in this implementation, when the second circuit board outputs a pair of differential electrical signals, the transmitter optical subassembly that supports only single-ended driving can further perform electrical-to-optical conversion on an electrical signal from the processing unit, to emit a service optical signal. There is no need to match a different second circuit board for the transmitter optical subassembly that supports single-ended driving, to ensure flexible matching between the first circuit board and the second circuit board.

Based on the first aspect, in an optional implementation, the first high-speed interface includes a fifth pin and a sixth pin, and both the fifth pin and the sixth pin are connected to the transmitter optical subassembly; the second high-speed interface includes a seventh pin and an eighth pin, the seventh pin is separately connected to the fifth pin and the processing unit, and the eighth pin is separately connected to the sixth pin and the processing unit; and the seventh pin is configured to receive a third electrical signal from the processing unit, and the eighth pin is configured to receive a fourth electrical signal from the processing unit, where the third electrical signal and the fourth electrical signal are a pair of differential electrical signals.

According to the optical module shown in this implementation, the transmitter optical subassembly is driven by using a differential electrical signal, and the transmitter optical subassembly can support transmission of an optical signal at a higher rate when a comparison with a manner of driving the transmitter optical subassembly by using a single-ended electrical signal is made.

Based on the first aspect, in an optional implementation, a board material of the first circuit board is different from a board material of the second circuit board, and an electrical signal transmission rate supported by the first circuit board is less than an electrical signal transmission rate supported by the second circuit board.

According to the optical module shown in this implementation, the electrical signal transmission rate supported by the first circuit board is less than the electrical signal transmission rate supported by the second circuit board. A board material that supports high-rate transmission of an electrical signal does not need to be used for the first board material of the first circuit board. This effectively reduces costs of the first circuit board, and further reduces overall manufacturing costs of the optical module.

Based on the first aspect, in an optional implementation, that the first circuit board and the second circuit board are fastened to the connection board includes: Two sides of a same surface of the connection board respectively include a first region and a second region, the first region includes a first positioning member, the first positioning member is configured to fasten the first circuit board to the first region, the second region includes a second positioning member, and the second positioning member is configured to fasten the second circuit board to the second region.

According to the optical module shown in this implementation, precise alignment between the first connection port and the second connection port can be implemented, a thread of the lead that connects the first connection port and the second connection port is effectively reduced, and connection accuracy and efficiency are improved.

Based on the first aspect, in an optional implementation, the first circuit board includes a first daughter board and a second daughter board, the first connection port includes a first connection subport and a second connection subport, the first daughter board includes the transmitter optical subassembly and the first connection subport, the second daughter board includes the receiver optical subassembly and the second connection subport, the transmitter optical subassembly is connected to the first connection subport, and the receiver optical subassembly is connected to the second connection subport; the connection board is configured to align the first connection subport with the second connection port, and the connection board is further configured to align the second connection subport with the second connection port; and the first connection subport is connected to the second connection port by using a lead, and the second connection subport is connected to the second connection port by using a lead.

According to the optical module shown in this implementation, the first daughter board and the second daughter board can be separately processed, to further reduce a manufacturing process of the optical module. In addition, a procedure such as a test can be separately performed on the first daughter board and the second daughter board, to ensure that both the first daughter board and the second daughter board are good products that can work independently and normally. This effectively increases a product yield rate of the optical module.

Based on the first aspect, in an optional implementation, the first circuit board further includes a driver and/or an amplifier, the driver is separately connected to the transmitter optical subassembly and the first connection port, and the amplifier is separately connected to the receiver optical subassembly and the first connection port.

According to the optical module shown in this implementation, when the first circuit board further includes a driver and/or an amplifier, power of an electrical signal transmitted by the first circuit board is high, and signal quality is good. This reduces an area and costs of the second circuit board.

Based on the first aspect, in an optional implementation, the transmitter optical subassembly and the first connection port are separately connected to the driver by using a first electric-conductor, and an electrical signal transmission rate supported by the first electric-conductor is greater than the electrical signal transmission rate supported by the first circuit board; and the receiver optical subassembly and the first connection port are separately connected to the amplifier by using a second electric-conductor, and an electrical signal transmission rate supported by the second electric-conductor is greater than the electrical signal transmission rate supported by the first circuit board.

According to the optical module shown in this implementation, an electrical signal transmitted by the driver or the amplifier is a high-speed electrical signal. To reduce costs of the first circuit board, a transmission path of the service electrical signal transmitted by the driver or the amplifier does not need to pass through a trace of the first circuit board, and an electric-conductor is separately disposed independent of the trace of the first circuit board. Therefore, the optical module may use a first circuit board that supports a low electrical signal transmission rate, to reduce costs of the first circuit board.

According to a second aspect of embodiments of the present invention, an optical-to-electrical conversion module is provided. The optical-to-electrical conversion module includes a first circuit board. The first circuit board includes a transmitter optical subassembly and a receiver optical subassembly. The first circuit board further includes a first connection port. The transmitter optical subassembly and the receiver optical subassembly are separately connected to the first connection port. The first circuit board is configured to be fastened to a connection board. The connection board is further configured to fasten a second circuit board. The first connection port is aligned with a second connection port included in the second circuit board by using the connection board. The first connection port and the second connection port are connected by using leads. For descriptions of beneficial effects of this aspect, refer to the first aspect. Details are not described.

Based on the second aspect, in an optional implementation, the first connection port includes a first high-speed interface, the first high-speed interface is any high-speed interface included in the first connection port, and the first high-speed interface is aligned with a second high-speed interface included in the second connection port by using the connection board; and the first connection port includes a first low-speed interface, the first low-speed interface is any low-speed interface included in the first connection port, and the first low-speed interface is aligned with a second low-speed interface included in the second connection port by using the connection board.

Based on the second aspect, in an optional implementation, the first high-speed interface and the second high-speed interface are connected by using the first lead, and the first low-speed interface and the second low-speed interface are connected by using the second lead.

Based on the second aspect, in an optional implementation, an electrical signal transmission rate supported by the first lead is greater than an electrical signal transmission rate supported by the second lead.

Based on the second aspect, in an optional implementation, in the first connection port, the first low-speed interface is located between two adjacent first high-speed interfaces.

Based on the second aspect, in an optional implementation, the first high-speed interface includes a first pin and a second pin, the first pin is connected to the transmitter optical subassembly, and the second pin is grounded; and the first pin is configured to receive a first electrical signal from the second high-speed interface, and the second pin is configured to receive a second electrical signal from the second high-speed interface, where the first electrical signal and the second electrical signal are a pair of differential electrical signals.

Based on the second aspect, in an optional implementation, the first circuit board includes a first daughter board and a second daughter board, the first connection port includes a first connection subport and a second connection subport, the first daughter board includes the transmitter optical subassembly and the first connection subport, the second daughter board includes the receiver optical subassembly and the second connection subport, the transmitter optical subassembly is connected to the first connection subport, and the receiver optical subassembly is connected to the second connection subport; the first connection subport is aligned with the second connection port by using the connection board, and the second connection subport is aligned with the second connection port by using the connection board; and the first connection subport is connected to the second connection port by using a lead, and the second connection subport is connected to the second connection port by using a lead.

Based on the second aspect, in an optional implementation, the first circuit board further includes a driver and/or an amplifier, the driver is separately connected to the transmitter optical subassembly and the first connection port, and the amplifier is separately connected to the receiver optical subassembly and the first connection port.

Based on the second aspect, in an optional implementation, the transmitter optical subassembly and the first connection port are separately connected to the driver by using a first electric-conductor, and an electrical signal transmission rate supported by the first electric-conductor is greater than an electrical signal transmission rate supported by the first circuit board; and the receiver optical subassembly and the first connection port are separately connected to the amplifier by using a second electric-conductor, and an electrical signal transmission rate supported by the second electric-conductor is greater than the electrical signal transmission rate supported by the first circuit board.

According to a third aspect of embodiments of the present invention, an electrical processing module is provided. The electrical processing module includes a second circuit board. The second circuit board includes a processing unit. The second circuit board further includes a second connection port. The processing unit is connected to the second connection port. The second circuit board is configured to be fastened to a connection board. The connection board is further configured to fasten a first circuit board. The second connection port is aligned with a first connection port included in the first circuit board by using the connection board. The first connection port and the second connection port are connected by using leads. For descriptions of beneficial effects of this aspect, refer to the first aspect. Details are not described.

Based on the third aspect, in an optional implementation, the second connection port includes a second high-speed interface, the second high-speed interface is a high-speed interface included in the second connection port, and the second high-speed interface is aligned with a first high-speed interface included in the first connection port by using the connection board; and the second connection port includes a second low-speed interface, the second low-speed interface is a low-speed interface included in the second connection port, and the second low-speed interface is aligned with a first low-speed interface included in the first connection port by using the connection board.

Based on the third aspect, in an optional implementation, the first high-speed interface and the second high-speed interface are connected by using the first lead, and the first low-speed interface and the second low-speed interface are connected by using the second lead.

Based on the third aspect, in an optional implementation, an electrical signal transmission rate supported by the first lead is greater than an electrical signal transmission rate supported by the second lead.

Based on the third aspect, in an optional implementation, in the second connection port, the second low-speed interface is located between two adjacent second high-speed interfaces.

According to a fourth aspect of embodiments of the present invention, an assembly method is provided. The assembly method is used to assemble an optical module. The optical module includes a first circuit board, a second circuit board, and a connection board. The method includes: fastening the first circuit board to the connection board; fastening the second circuit board to the connection board, where a first connection port of the first circuit board is aligned with a second connection port of the second circuit board by using the connection board; and connecting the first connection port and the second connection port by using leads. For descriptions of beneficial effects of this aspect, refer to the first aspect. Details are not described.

Based on the fourth aspect, in an optional implementation, the connecting the first connection port and the second connection port by using leads includes: connecting a first high-speed interface of the first connection port and a second high-speed interface of the second connection port by using a first lead, where the first high-speed interface is any high-speed interface included in the first connection port, the second high-speed interface is a high-speed interface included in the second connection port, and the first high-speed interface is aligned with the second high-speed interface by using the connection board; and connecting a first low-speed interface of the first connection port and a second low-speed interface of the second connection port by using a second lead, where the first low-speed interface is any low-speed interface included in the first connection port, the second low-speed interface is a low-speed interface included in the second connection port, and the first low-speed interface is aligned with the second low-speed interface by using the connection board.

Based on the fourth aspect, in an optional implementation, two sides of a same surface of the connection board respectively include a first region and a second region, the first region includes a first positioning member, the second region includes a second positioning member, and the fastening the first circuit board to the connection board includes: fastening the first circuit board to the first region by using the first positioning member; and the fastening the second circuit board to the connection board includes: fastening the second circuit board to the second region by using the second positioning member.

According to a fifth aspect of embodiments of the present invention, an optical communication device is provided. The optical communication device includes a communication board. The optical communication device further includes at least one optical module connected to the communication board. The optical module is shown in any one of the first aspect.

### BRIEF DESCRIPTION OF DRAWINGS

FIG. 1 is an example diagram of a structure of an embodiment of an optical communication system according to an embodiment of this application;
FIG. 2a is an example diagram of a structure of a first embodiment of an optical communication device according to an embodiment of this application;
FIG. 2b is an example diagram of a structure of a second embodiment of an optical communication device according to an embodiment of this application;
FIG. 3a is an example diagram of a side-view structure of a first embodiment of an optical module according to an embodiment of this application;
FIG. 3b is an example diagram of a top-view structure of the optical module shown in FIG. 3a;
FIG. 3c is an example diagram of a top-view structure of a part of the optical module shown in FIG. 3b;
FIG. 4 is an example diagram of alignment between a first connection port and a second connection port according to an embodiment of this application;
FIG. 5a is an example diagram of a structure of a first embodiment of a connection board according to an embodiment of this application;
FIG. 5b is an example diagram of a structure in which a first circuit board is fastened to the connection board shown in FIG. 5a;
FIG. 5c is an example diagram of a structure in which a first circuit board and a second circuit board are fastened to the connection board shown in FIG. 5a;
FIG. 6a is an example diagram of a structure of a second embodiment of a connection board according to an embodiment of this application;
FIG. 6b is an example diagram of a structure in which a first circuit board is fastened to the connection board shown in FIG. 6a;
FIG. 6c is an example diagram of a structure in which a first circuit board and a second circuit board are fastened to the connection board shown in FIG. 6a;
FIG. 7 is an example diagram of a side-view structure of a second embodiment of an optical module according to an embodiment of this application;
FIG. 8 is an example diagram of a top-view structure of a first embodiment of an optical module according to an embodiment of this application;
FIG. 9 is an example diagram of a structure of a low-speed interface of the optical module shown in FIG. 8;
FIG. 10 is an example diagram of a top-view structure of a second embodiment of an optical module according to an embodiment of this application;
FIG. 11 is an example diagram of a top-view structure of a third embodiment of an optical module according to an embodiment of this application;
FIG. 12 is an example diagram of a top-view structure of a fourth embodiment of an optical module according to an embodiment of this application;
FIG. 13 is an example diagram of a top-view structure of a fifth embodiment of an optical module according to an embodiment of this application;
FIG. 14 is an example diagram of a first application scenario of an optical-to-electrical conversion module according to an embodiment of this application;
FIG. 15 is an example diagram of a second application scenario of an optical-to-electrical conversion module according to an embodiment of this application;
FIG. 16 is an example diagram of a third application scenario of an optical-to-electrical conversion module according to an embodiment of this application; and
FIG. 17 is a flowchart of steps of an assembly method according to an embodiment of this application.

### DESCRIPTION OF EMBODIMENTS

The following clearly and completely describes the technical solutions in embodiments of the present invention with reference to the accompanying drawings in embodiments of the present invention. It is clear that the described embodiments are merely some rather than all of embodiments of the present invention. All other embodiments obtained by persons skilled in the art based on embodiments of the present invention without creative efforts shall fall within the protection scope of the present invention.

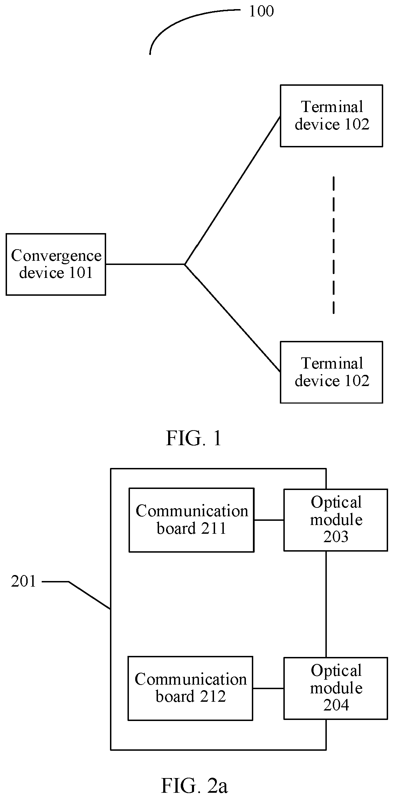

A structure of an optical communication system to which this application is applied is first described with reference to FIG. 1. FIG. 1 is an example diagram of a structure of an embodiment of an optical communication system according to an embodiment of this application. The optical communication system 100 shown in this embodiment includes a convergence device 101 and one or more terminal devices 102. A quantity of terminal devices 102 included in the optical communication system 100 is not limited in this embodiment. Each terminal device 102 included in the optical communication system 100 is connected to the convergence device 101.

The optical communication system 100 shown in this embodiment may be a passive optical network (passive optical network, PON). In this case, the convergence device 101 is an optical line terminal (optical line terminal, OLT), and the terminal device 102 is an optical network unit (optical network unit, ONU). The convergence device 101 shown in this embodiment may be directly connected to each terminal device 102, or the convergence device 101 is connected to each terminal device 102 through a point-to-multipoint optical splitting device. Descriptions of a type of the optical communication system 100 in this embodiment are an optional example, and are not limited. For example, the optical communication system 100 may alternatively be an industrial optical network, a data center network, a wavelength division multiplexing network, or an optical transport network (optical transport network, OTN).

A structure of an optical communication device provided in an embodiment of this application is described with reference to FIG. 2a. FIG. 2a is an example diagram of a structure of a first embodiment of an optical communication device according to an embodiment of this application. The optical communication device shown in this embodiment may be the convergence device 101 shown in FIG. 1 or the terminal device 102 shown in FIG. 1. A specific device type of the optical communication device is not limited in this embodiment. For example, the optical communication device may alternatively be a router, a switch, a server, or an OTN transport device.

The optical communication device specifically includes a network device 201 and an optical module inserted into and fastened to a panel of the network device 201. The optical module shown in this embodiment may also be referred to as a high-speed pluggable optical module. In this embodiment, an example in which two optical modules, namely, an optical module 203 and an optical module 204, are inserted into the panel of the network device 201 is used. It should be noted that a quantity of optical modules inserted into the panel of the network device 201 is not limited in this embodiment. The optical module 203 is connected to a communication board 211 in the network device 201, and the optical module 204 is connected to a communication board 212 in the network device 201. It should be noted that a quantity of communication boards included in the network device 201 is not limited in this embodiment. A quantity of optical modules connected to each communication board included in the network device 201 is not limited in this embodiment.

For example, if the network device 201 is the convergence device shown in FIG. 1, and the network device 201 is configured to send a downlink service optical signal to a terminal device, the communication board 211 generates a downlink service electrical signal, and sends the downlink service electrical signal to the optical module 203. The optical module 203 performs electrical-to-optical conversion on the downlink service electrical signal, to obtain a downlink service optical signal. The optical module 203 sends the downlink service optical signal to the terminal device through an optical cable connected between the optical module 203 and the terminal device. For another example, if the network device 201 is a convergence device, and the network device 201 is configured to receive an uplink service optical signal from a terminal device, the optical module 204 of the network device 201 receives the uplink service optical signal through an optical cable connected between the optical module 204 and the terminal device. The optical module 204 performs optical-to-electrical conversion on the uplink service optical signal, to obtain an uplink service electrical signal, and the optical module 204 sends the uplink service electrical signal to the communication board 212. The communication board 212 processes the uplink service electrical signal. If the network device 201 shown in this embodiment is a terminal device, for descriptions of a process in which the network device 201 receives a downlink service optical signal from a convergence device and sends an uplink service optical signal to the convergence device, refer to the foregoing descriptions of a case in which the network device 201 is a convergence device. Details are not described.

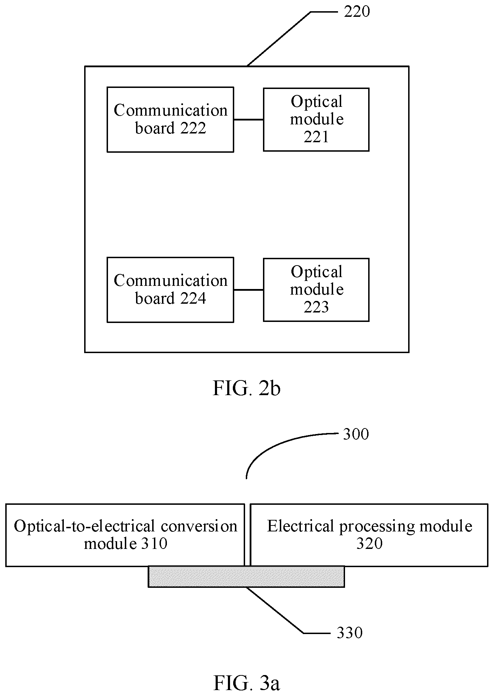

Still refer to FIG. 2b. FIG. 2b is an example diagram of a structure of a second embodiment of an optical communication device according to an embodiment of this application. The optical communication device 220 shown in this embodiment may be the convergence device shown in FIG. 1 or the terminal device shown in FIG. 1. The optical communication device 220 includes a communication board inside. In this embodiment, a quantity of communication boards included in the optical communication device 220 is not limited. In this embodiment, the optical communication device 220 includes two communication boards: a communication board 222 and a communication board 224. The optical communication device 220 further includes an optical module 221 and an optical module 223 that are located inside the optical communication device 220. The optical module 221 is connected to the communication board 222, and the optical module 223 is connected to the communication board 224. A quantity of optical modules located inside the optical communication device 220 and a quantity of optical modules connected to each communication board are not limited in this embodiment. It may be learned, with reference to FIG. 2a and FIG. 2b, that the optical module shown in this embodiment may be inserted into a panel of a network device, as shown in FIG. 2a, and the optical module may alternatively be located inside the optical communication device, as shown in FIG. 2b.

A structure of an optical module provided in this application is described below by using an example with reference to FIG. 3a. FIG. 3a is an example diagram of a side-view structure of a first embodiment of an optical module according to an embodiment of this application. The optical module 300 shown in this embodiment includes an optical-to-electrical conversion module 310, an electrical processing module 320, and a connection board 330. The connection board 330 is configured to fasten the optical-to-electrical conversion module 310 and the electrical processing module 320. Specifically, a bottom surface of the optical-to-electrical conversion module 310 and a bottom surface of the electrical processing module 320 are fastened to the connection board 330.

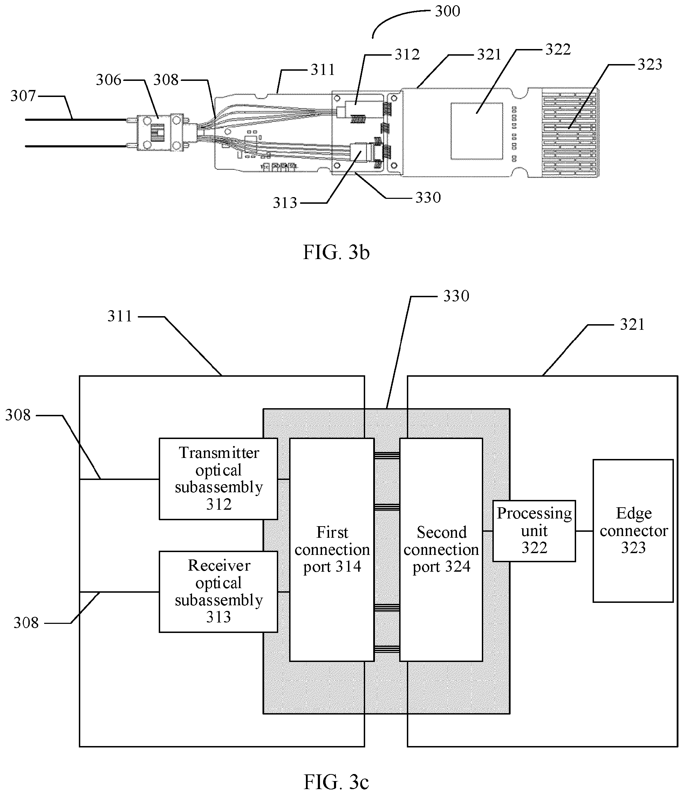

Specific structures of the optical-to-electrical conversion module 310 and the electrical processing module 320 are described with reference to FIG. 3b and FIG. 3c. FIG. 3b is an example diagram of a top-view structure of an optical module according to an embodiment of this application. FIG. 3c is an example diagram of a top-view structure of a part of the optical module shown in FIG. 3b. The optical-to-electrical conversion module 310 shown in this embodiment includes a first circuit board 311. The electrical processing module 320 includes a second circuit board 321. The first circuit board 311 shown in this embodiment may be a printed circuit board (printed circuit board, PCB). Specifically, the first circuit board includes one or more layers of board materials, and an electrically conductive trace is arranged on one or two sides of each board material. A type of the board material is not limited in this embodiment. For example, the board material may be a paper base, a glass fiber cloth base, a composite base, a ceramic base, or a metal core base. For descriptions of the second circuit board 321, refer to the descriptions of the first circuit board 311. Details are not described.

The first circuit board 311 includes a transmitter optical subassembly 312 and a receiver optical subassembly 313. The optical module 300 further includes an optical fiber connector 306. The optical fiber connector 306 is configured to connect an external optical cable 307 and an internal optical cable 308. The external optical cable 307 is located outside a housing of the optical module 300, and the internal optical cable 308 is located inside the housing of the optical module. For example, if the optical module 300 is connected to a convergence device, one end of the external optical cable 307 is connected to the optical fiber connector 306, and the other end is connected to a terminal device. For another example, if the optical module 300 is connected to a terminal device, one end of the external optical cable 307 is connected to the optical fiber connector 306, and the other end is connected to a convergence device. The internal optical cable 308 is separately connected to the transmitter optical subassembly 312 and the receiver optical subassembly 313. After receiving a service optical signal from the external optical cable 307, the optical fiber connector 306 sends the service optical signal to the receiver optical subassembly 313 through the internal optical cable 308. The receiver optical subassembly 313 performs optical-to-electrical conversion on the service optical signal, to obtain a service electrical signal. Alternatively, the transmitter optical subassembly 312 performs electrical-to-optical conversion on a service electrical signal from a communication board, to obtain a service optical signal, the internal optical cable 308 receives the service optical signal from the transmitter optical subassembly 312, and the internal optical cable 308 sends the service optical signal to the external optical cable 307 through the optical fiber connector 306. It should be noted that descriptions of a type of the optical fiber connector 306 in this embodiment are an optional example, and are not limited. A specific type of the optical fiber connector 306 shown in this embodiment may be any one of the following:
a multi-fiber push on (multi fiber push on, MPO) connector, a ferrule connector (ferrule connector, FC), a square connector (square connector, SC), a lucent connector (lucent connector, LC), a straight tip (straight tip, ST) connector, a fiber distributed data interface (fiber distributed data interface, IFDD) connector, or the like.

The second circuit board 321 of the electrical processing module 320 includes a processing unit 322. The processing unit 322 is separately connected to the transmitter optical subassembly 312 and the receiver optical subassembly 313. A form of the processing unit 322 is not limited in this embodiment. For example, the processing unit 322 may be one or more chips, or one or more integrated circuits. For example, the processing unit 322 may be one or more optical digital signal processors (optical digital signal processor, oDSP), field programmable gate arrays (field-programmable gate array, FPGA), application-specific integrated circuits (application specific integrated circuit, ASIC), systems on chips (system on chip, SoC), central processing units (central processor unit, CPU), network processors (network processor, NP), microcontroller units (micro controller unit, MCU), programmable logic devices (programmable logic device, PLD), other integrated chips, or any combination of the foregoing chips or processors. Details are not described.

The second circuit board 321 further includes an edge connector 323 connected to the processing unit 322. The edge connector 323 is connected to a communication board in an optical communication device, and receiving and sending of an electrical signal between the processing unit 322 and the communication board are implemented based on the edge connector 323.

For example, if the optical communication device is configured to emit a service optical signal, the communication board in the optical communication device sends a service electrical signal to the processing unit 322 through the edge connector 323. The processing unit 322 is connected to the transmitter optical subassembly 312. The processing unit 322 sends a processed service electrical signal to the transmitter optical subassembly 312. The transmitter optical subassembly 312 performs electrical-to-optical conversion on the service electrical signal, to output a service optical signal through the optical fiber connector 306. If the optical communication device is configured to receive a service optical signal, the receiver optical subassembly 313 receives the service optical signal through the optical fiber connector 306, the receiver optical subassembly 313 performs optical-to-electrical conversion on the service optical signal, to obtain a service electrical signal, and the processing unit 322 sends a processed service electrical signal to the communication board in the optical communication device through the edge connector 323. When obtaining the service electrical signal, the processing unit 322 performs signal processing on the service electrical signal, for example, signal amplification, signal retiming, signal shaping, signal regeneration, and signal encoding and decoding.

The following describes a specific manner in which the processing unit 322 shown in this embodiment is separately connected to the transmitter optical subassembly 312 and the receiver optical subassembly 313.

The first circuit board 311 shown in this embodiment includes a first connection port 314, and the second circuit board 321 includes a second connection port 324. The transmitter optical subassembly 312 and the receiver optical subassembly 313 are separately connected to the first connection port 314, and the second connection port 324 is connected to the processing unit 322. The first connection port 314 and the second connection port 324 are connected by using leads. It may be understood that the transmitter optical subassembly 312 is sequentially connected to the processing unit 322 through the first connection port 314 and the second connection port 324. The receiver optical subassembly 313 is sequentially connected to the processing unit 322 through the first connection port 314 and the second connection port 324. Specifically, the first connection port 314 includes a plurality of pins, and the second connection port 324 includes a plurality of pins. Any one of the plurality of pins included in the first connection port 314 is connected to one pin included in the second connection port 324 by using a lead. For example, the first connection port 314 includes pins A1 and A2 to AN, and the second connection port 324 includes pins B1 and B2 to BN, where N is any positive integer. The pin A1 is connected to the pin B1 by using a lead, the pin A2 is connected to the pin B2 by using a lead, and by analogy, the pin AN is connected to the pin BN by using a lead. The lead shown in this embodiment may be made of one or more of electrically conductive metal materials such as gold, aluminum, copper, steel, or nickel. For example, in this embodiment, the pin A1 and the pin B1 are connected through gold wire bonding. Gold wire bonding specifically means that the pin A1 and the pin B1 are directly combined into one by using a gold wire in a manner such as thermo compression bonding, ultrasonic bonding, or thermo compression ultrasonic bonding.

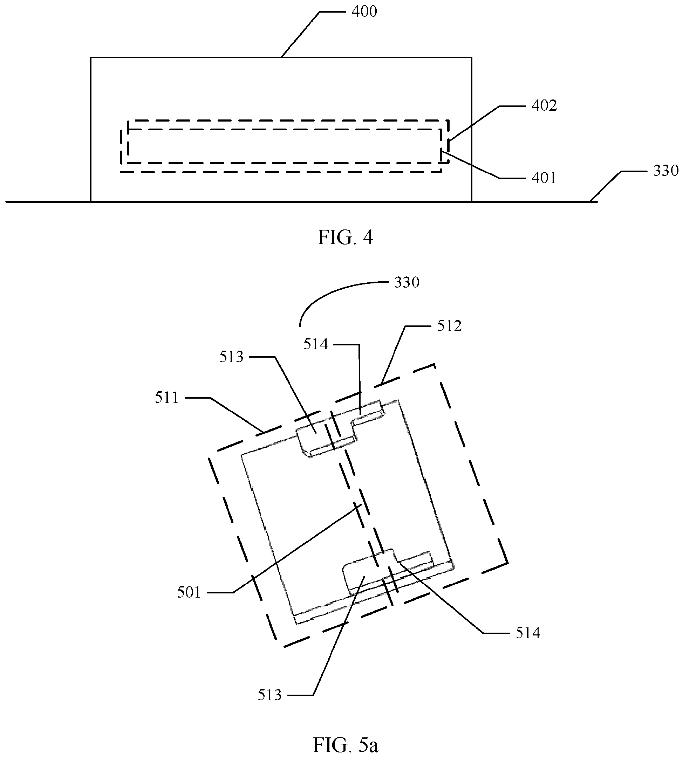

The optical module shown in this embodiment further includes the connection board 330. The first circuit board 311 and the second circuit board 321 are fastened to the connection board 330, and the connection board 330 is configured to align the first connection port 314 with the second connection port 324. Still refer to the foregoing example. Alignment between the first connection port 314 and the second connection port 324 means that a position of the pin A1 is aligned with a position of the pin B1, a position of the pin A2 is aligned with a position of the pin B2, and by analogy, a position of the pin AN is aligned with a position of the pin BN. Alignment between the first connection port 314 and the second connection port 324 is described with reference to FIG. 4. FIG. 4 is an example diagram of alignment between a first connection port and a second connection port according to an embodiment of this application. The first connection port 314 has a first orthographic projection 401 on a projection surface 400. Specifically, a projected light beam perpendicular to the projection surface 400 is irradiated on the first connection port 314, to form the first orthographic projection 401 on the projection surface 400. The projection surface 400 is a surface perpendicular to the connection board 330. The projected light beam includes a plurality of projection rays that are parallel to each other and that are perpendicular to the projection surface 400, and a transmission optical path of the projected light beam can completely cover the first connection port 314. The second connection port 324 has a second orthographic projection 402 on the projection surface 400. For descriptions of a manner of forming the second orthographic projection 402, refer to the descriptions of the manner of forming the first orthographic projection 401. Details are not described. The first orthographic projection 401 and the second orthographic projection 402 at least partially overlap. As shown in FIG. 4, an example in which the first orthographic projection 401 and the second orthographic projection 402 partially overlap on the projection surface 400 is used. In another example, the first orthographic projection 401 and the second orthographic projection 402 may completely overlap on the projection surface 400.

The following describes beneficial effects of aligning the first connection port 314 with the second connection port 324.

In this embodiment, the first connection port 314 is aligned with the second connection port 324 by using the connection board 330, to avoid an offset or an error in relative positions of the first connection port 314 and the second connection port 324, and ensure a successful connection between the first connection port 314 and the second connection port 324 by using the leads. When the first connection port 314 is aligned with the second connection port 324, a thread length of the lead connected between the first connection port 314 and the second connection port 324 can be effectively reduced, and further an insertion loss of an electrical signal transmitted between the first connection port 314 and the second connection port 324 is reduced. The thread length of the lead connected between the first connection port 314 and the second connection port 324 is a length of the lead connected between the first connection port 314 and the second connection port 324. A reduction in the thread length reduces attenuation of the electrical signal transmitted between the first connection port and the second connection port, improves signal quality of the electrical signal, and improves transmission efficiency of the transmitted electrical signal. The first connection port 314 is aligned with the second connection port 324. Therefore, no operational interference is caused to a lead bonding process, efficiency and accuracy of connecting the first connection port 314 and the second connection port 324 by using the leads are improved, and a case in which the first connection port 314 and the second connection port 324 cannot be connected by using the leads is avoided.

The following optionally describes a manner in which the connection board 330 fastens the optical-to-electrical conversion module 310 and the electrical processing module 320.

### Optional manner 1

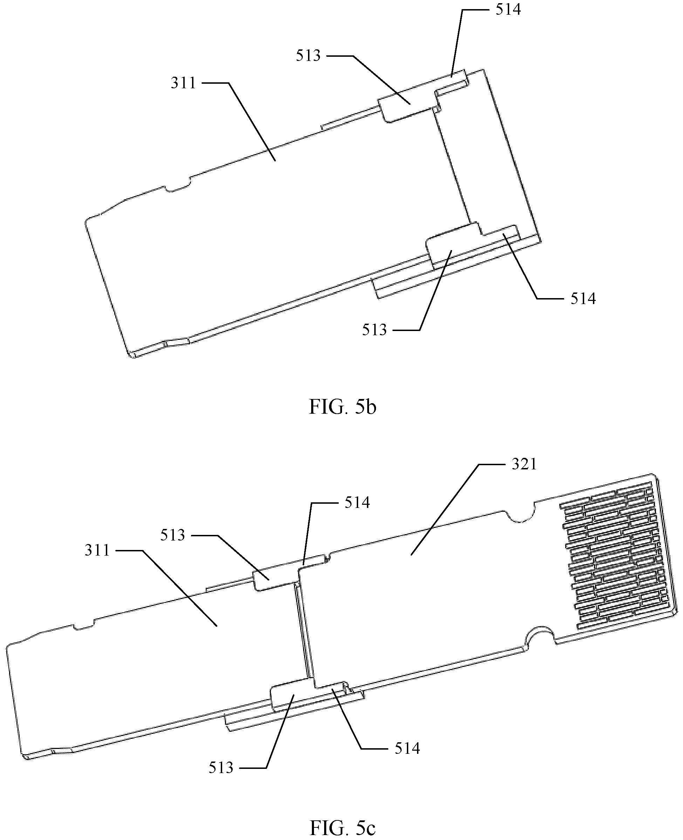

Refer to FIG. 5a, FIG. 5b, and FIG. 5c. FIG. 5a is an example diagram of a structure of a first embodiment of a connection board according to an embodiment of this application. FIG. 5b is an example diagram of a structure in which a first circuit board is fastened to the connection board shown in FIG. 5a. FIG. 5c is an example diagram of a structure in which a first circuit board and a second circuit board are fastened to the connection board shown in FIG. 5a. The connection board 330 has a surface 501 facing the optical-to-electrical conversion module 310 and the electrical processing module 320. The surface 501 has a first region 511 and a second region 512. The first region 511 is configured to fasten the first circuit board 311, and the second region 512 is configured to fasten the second circuit board 321. The first region 511 includes a first positioning member 513, and the first positioning member 513 is a limiting step protruding on the surface 501. A first guide rail is formed between the first positioning member 513 and the first region 511. The second region 512 includes a second positioning member 514, and the second positioning member 514 is a limiting step protruding on the surface 501. A second guide rail is formed between the second positioning member 514 and the second region 512. There is a limiting surface between the first guide rail and the second guide rail. Two sides of the first circuit board 311 can respectively slide in guide directions of first guide rails of two first positioning members 513 until an end part of the first circuit board 311 abuts against and is fastened to the limiting surface. Two sides of the second circuit board 321 can respectively slide in guide directions of second guide rails of two second positioning members 514 until an end part of the second circuit board 321 abuts against and is fastened to the limiting surface.

In this embodiment, the two sides of the first circuit board 311 are inserted into and fastened to the first guide rail, the two sides of the second circuit board 321 are inserted into and fastened to the second guide rail, and the first circuit board 311 and the second circuit board 321 separately abut against the limiting surface, so that the first circuit board 311 and the second circuit board 321 are fastened to the connection board 330, to ensure alignment between the first connection port 314 and the second connection port 324.

To improve stability of a structure in which the first circuit board 311 and the second circuit board 321 are fastened to the connection board 330, there is a bonding layer on the surface 501 of the connection board 330 and/or a surface that is of the first circuit board 311 and that faces the connection board 330. The bonding layer is configured to bond and fasten the first circuit board 311 to the surface 501. For descriptions of fastening the second circuit board 321 to the surface 501 by using a bonding layer, refer to the descriptions of fastening the first circuit board 311 to the surface 501 by using the bonding layer. Details are not described.

### Optional manner 2

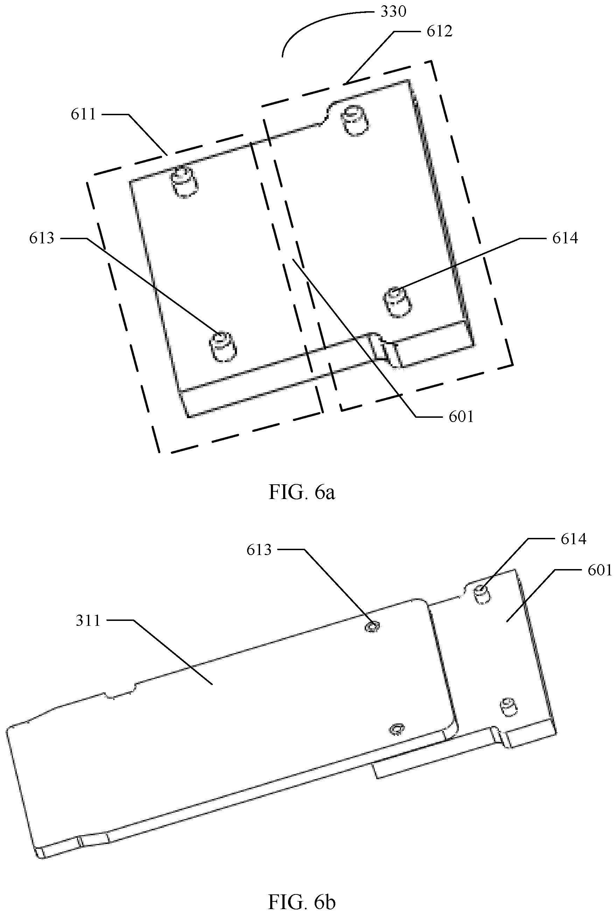

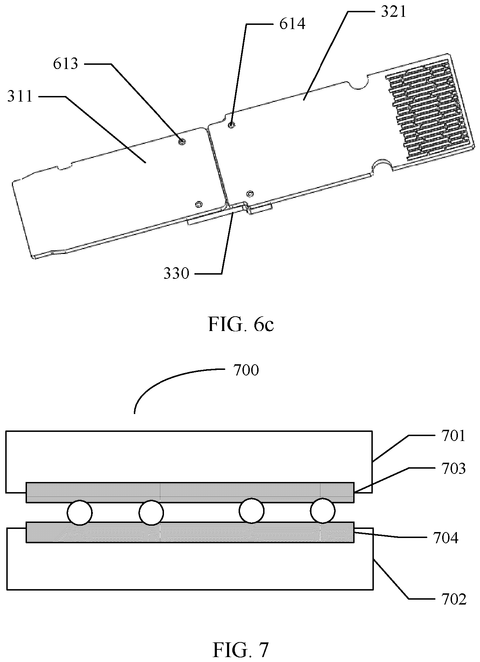

Refer to FIG. 6a, FIG. 6b, and FIG. 6c. FIG. 6a is an example diagram of a structure of a second embodiment of a connection board according to an embodiment of this application. FIG. 6b is an example diagram of a structure in which a first circuit board is fastened to the connection board shown in FIG. 6a. FIG. 6c is an example diagram of a structure in which a first circuit board and a second circuit board are fastened to the connection board shown in FIG. 6a. There is a first region 611 and a second region 612 on a surface 601 that is of the connection board 330 and that faces the optical-to-electrical conversion module 310 and the electrical processing module 320. The first region 611 is configured to fasten the first circuit board 311, and the second region 612 is configured to fasten the second circuit board 321. The first region 611 includes a first positioning member, and the first positioning member is a first positioning pin 613 protruding on the surface 601. A quantity of first positioning pins 613 is not limited in this embodiment. For example, the first positioning pins 613 are distributed at positions, on the connection board 330, opposite to the first circuit board 311. The second region 612 includes a second positioning member, and the second positioning member is a second positioning pin 614 protruding on the surface 601. For descriptions of the second positioning pin 614, refer to descriptions of the first positioning pin 613. Details are not described. On a surface that is of the first circuit board 311 and that faces the surface 601, a first positioning hole is disposed at a position opposite to a position of each first positioning pin 613. The first positioning pin 613 is inserted into and fastened to the first positioning hole, to fasten the first circuit board 311 to the connection board 330. On a surface that is of the second circuit board 311 and that faces the surface 601, a second positioning hole is disposed at a position opposite to a position of each second positioning pin 614. The second positioning pin 614 is inserted into and fastened to the second positioning hole, to fasten the second circuit board 311 to the connection board 330. To improve stability of the structure, in this embodiment, the first positioning pin 613 is in an interference fit with the first positioning hole, and the second positioning pin 614 is in an interference fit with the second positioning hole.

In this embodiment, when the first positioning pin 613 is inserted into and fastened to the first positioning hole, and the second positioning pin 614 is inserted into and fastened to the second positioning hole, alignment between the first connection port 314 and the second connection port 324 can be effectively ensured.

In this manner, stability of a structure in which the first circuit board 311 and the second circuit board 321 are fastened to the connection board 330 may be further improved by using a bonding layer. For descriptions of the bonding layer, refer to FIG. 5a to FIG. 5c. Details are not described.

It should be noted that in this embodiment, descriptions of structures of the first positioning member and the second positioning member that are used to align the first connection port with the second connection port are optional examples, and are not limited. For example, both the first positioning member and the second positioning member may be buckles, the first circuit board is provided with a clamping groove for clamping with and fastening to the buckle, and the second circuit board is also provided with a clamping groove for clamping with and fastening to the buckle. An example in which the first circuit board 311 is first fastened to the connection board, and then the second circuit board 321 is fastened to the connection board is used above. This is not limited. For another example, the second circuit board 321 may be first fastened to the connection board, and then the first circuit board 311 may be fastened to the connection board. For another example, the first circuit board 311 and the second circuit board 321 may be simultaneously fastened to the connection board. For example, the structures of the first positioning member and the second positioning member are the same. In another example, the structures of the first positioning member and the second positioning member may be different. For example, the structure of the first positioning member may be a positioning pin, and the second positioning member is a buckle. The connection board shown in this embodiment may be a part of the housing of the optical module, or the connection board may be located inside the housing of the optical module, and the connection board is fastened inside the housing of the optical module.

A material of the connection board is not limited in this embodiment, and the connection board can securely fasten the first circuit board and the second circuit board. For example, the material of the connection board may be a metal material such as tungsten or copper, or may be a non-metal material such as ceramic. A quantity of connection boards is not limited in this embodiment. For example, there may be one or more connection boards.

After the first circuit board 311 and the second circuit board 321 shown in this embodiment are fastened to the connection board 330, the first connection port 314 of the first circuit board 311 and the second connection port 324 of the second circuit board 321 are connected by using the leads, to effectively avoid a case in which the first circuit board 311 and the second connection board 302 are detached from the connection board 330. Even if an environment in which the optical module is located changes sharply, for example, a collision or fall occurs, because the connection board has a function of fastening the first circuit board 311 and the second circuit board 321, a case in which the first circuit board 311 and the second connection board 302 are detached from the connection board 330 is effectively avoided, a case in which the lead connected between the first connection port and the second connection port is broken is avoided, stability of a connection relationship between the first connection port and the second connection port is improved, transmission of an electrical signal between the first connection port and the second connection port is effectively ensured, and further security and a service life of the optical module are ensured.

According to the optical module shown in this embodiment, the optical-to-electrical conversion module and the electrical processing module are spliced and fastened by using the connection board. Therefore, before the optical module is obtained through splicing, the optical-to-electrical conversion module and the electrical processing module can be separately processed, to reduce a manufacturing process of the optical module. In addition, a procedure such as a test can be separately performed on the optical-to-electrical conversion module and the electrical processing module, to ensure that both the optical-to-electrical conversion module and the electrical processing module are good products that can work independently and normally, and then the optical-to-electrical conversion module and the electrical processing module are spliced and fastened by using the connection board. This effectively increases a product yield rate of the optical module. Further, the optical-to-electrical conversion module and the electrical processing module may be separately designed and arranged, to improve flexibility of structures in the optical module and implement flexible combination of the structures in the optical module.

If the optical-to-electrical conversion module in the optical module is faulty, the optical-to-electrical conversion module may be directly removed from the connection board, the lead connected between the first connection port and the second connection port is removed, and a good optical-to-electrical conversion module is used as a replacement and installed in the optical module. For another example, if the electrical processing module is faulty, the electrical processing module is directly removed from the connection board, the lead connected between the first connection port and the second connection port is removed, and a good electrical processing module is used as a replacement and installed in the optical module. It may be learned that when the optical-to-electrical conversion module or the electrical processing module is faulty, the entire optical module does not need to be replaced, and only the faulty optical-to-electrical conversion module or electrical processing module needs to be replaced. This reduces difficulty in repairing the optical module, a material loss, and costs.

The first connection port of the optical-to-electrical conversion module and the second connection port of the electrical processing module are connected by using the leads, to effectively reduce an electrical connection thread between the first connection port and the second connection port, and effectively reduce attenuation of the electrical signal transmitted between the first connection port and the second connection port. For example, in a scenario in which a quantity of channels of an electrical signal supported by the electrical processing module increases, an optical-to-electrical conversion module that supports high bandwidth may be connected to the electrical processing module to form an optical module. It may be learned that in the scenario in which the quantity of channels of an electrical signal increases, matching between the optical-to-electrical conversion module and the electrical processing module can also be ensured, to ensure normal working of the optical module. For another example, with development of the digital economy, a requirement for traffic in production and life explosively increases, and an optical signal transmission rate supported by the optical module evolves to a high rate, for example, gradually evolves from an optical module that supports 25G gigabits per second (Gbps) to 400 Gbps. As the optical signal transmission rate supported by the optical module exponentially increases, in this scenario, an optical-to-electrical conversion module and an electrical processing module that are obtained after the optical signal transmission rate increases can be connected to form an optical module, to ensure that the optical module can still work normally when the optical signal transmission rate increases.

The first circuit board of the optical module shown in this embodiment includes the transmitter optical subassembly and the receiver optical subassembly, and the second circuit board of the optical module includes the processing unit. To ensure that the processing unit can process an electrical signal from the receiver optical subassembly or process an electrical signal from the communication board and then send the electrical signal to the transmitter optical subassembly, the second circuit board needs to support a high electrical signal transmission rate. The first circuit board includes a first board material, and the second circuit board includes a second board material. In this embodiment, an example in which the first board material is different from the second board material is used. Attenuation of an electrical signal in the first board material and the second board material that are different is different. Therefore, transmission rates of the electrical signal in the first board material and the second board material that are different are different. In this embodiment, an example in which attenuation of the electrical signal in the first board material is greater than attenuation of the electrical signal in the second board material is used. In this case, a transmission rate of the electrical signal in the first board material is less than a transmission rate of the electrical signal in the second board material. It may be understood that an electrical signal transmission rate supported by the first circuit board is less than an electrical signal transmission rate supported by the second circuit board. When the second circuit board shown in this embodiment supports a high electrical signal transmission rate, normal processing and transmission of the electrical signal by the processing unit can be effectively ensured. When the electrical signal transmission rate supported by the first circuit board is less than the electrical signal transmission rate supported by the second circuit board, a board material that supports high-rate transmission of an electrical signal does not need to be used for the first board material of the first circuit board. This effectively reduces costs of the first circuit board, and further reduces overall manufacturing costs of the optical module.

In addition to the foregoing functions of fastening the first circuit board and the second circuit board and aligning the first connection port with the second connection port, the connection board shown in this embodiment can further implement another function. For example, the connection board further fastens a heat sink configured to dissipate heat for the receiver optical subassembly, the transmitter optical subassembly, and the processing unit. The heat sink can dissipate heat absorbed from the optical module.

In this embodiment, an example in which the first connection port of the first circuit board and the second connection port of the second circuit board are connected by using the leads is used. In another example, the first circuit board further includes a first connector, the first connection port is located in the first connector, the second circuit board further includes a second connector, and the second connection port is located in the second connector. When the first connector is connected to the second connector in a plug-in manner, the first connection port is connected to the second connection port, to ensure transmission of an electrical signal between the optical-to-electrical conversion module and the electrical processing module. For another example, the optical module further includes a flexible printed circuit (flexible printed circuit, FPC), and the FPC is configured to connect the first connection port and the second connection port. The FPC may connect the first connection port and the second connection port in a manner such as a flexible board connector (FPC Connector), a rigid-flex board (Rigid-Flex Board), or soldering (Soldering).

In the foregoing embodiment, an example in which the optical-to-electrical conversion module and the electrical processing module are connected to form a planar structure is used. In another example, the optical-to-electrical conversion module and the electrical processing module may be in a stacked structure. For example, FIG. 7 is an example diagram of a side-view structure of a second embodiment of an optical module according to an embodiment of this application. An optical-to-electrical conversion module includes a first circuit board 701, an electrical processing module includes a second circuit board 702, and the first circuit board 701 and the second circuit board 702 are in a stacked state. In this embodiment, an example in which the first circuit board 701 is stacked on a top surface of the second circuit board 702 is used. In another example, the second circuit board 702 may be stacked on a top surface of the first circuit board 701. For descriptions of the first circuit board 701 and the second circuit board 702, refer to the foregoing embodiment. Details are not described. A first connection port 703 of the first circuit board 701 is connected to a second connection port 704 of the second circuit board 702. A connection manner between the first connection port 703 and the second connection port 704 is not limited in this embodiment. For example, a connection is implemented through soldering, or a connection is implemented by using a lead. In this embodiment, an example in which the first connection port 703 is located on a bottom surface of the first circuit board 701, and the second connection port 704 is located on the top surface of the second circuit board 702 is used. In another example, the first connection port and the second connection port may be located on same side edges of the first circuit board and the second circuit board.

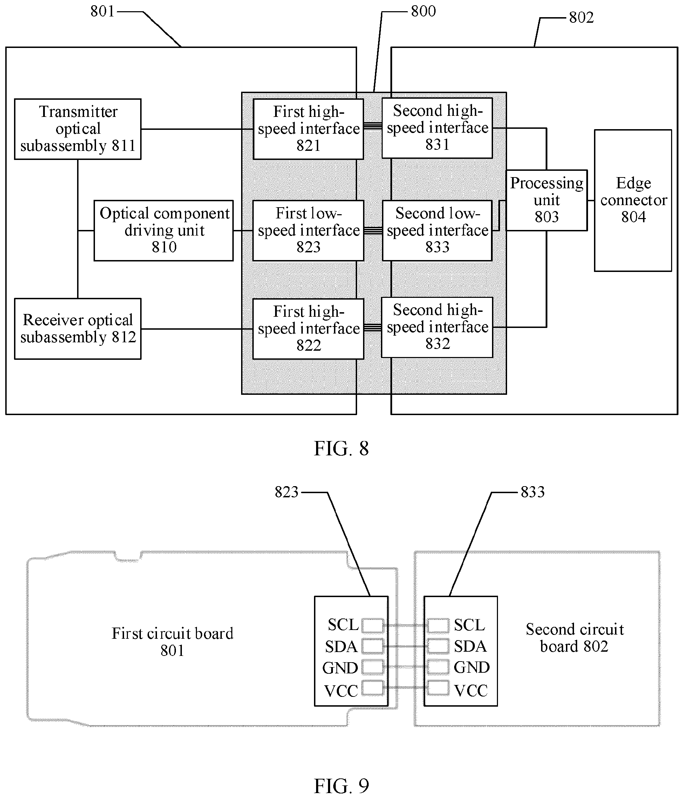

Structures of the first connection port and the second connection port are described in detail with reference to FIG. 8. FIG. 8 is an example diagram of a top-view structure of a first embodiment of an optical module according to an embodiment of this application. The optical module shown in this embodiment includes a first circuit board 801 and a second circuit board 802. The first circuit board 801 includes a transmitter optical subassembly 811 and a receiver optical subassembly 812. The second circuit board 802 includes a processing unit 803 and an edge connector 804 connected to the processing unit 803. For detailed descriptions, refer to the descriptions in FIG. 3b and FIG. 3c. Details are not described. A first connection port of the first circuit board 801 includes a first high-speed interface 821 and a first high-speed interface 822. A quantity of first high-speed interfaces included in the first circuit board 801 is not limited in this embodiment. Optionally, the transmitter optical subassembly 811 and the receiver optical subassembly 812 may be connected to different first high-speed interfaces. For example, the transmitter optical subassembly 811 is connected to the first high-speed interface 821, and the receiver optical subassembly 812 is connected to the first high-speed interface 822. Alternatively, optionally, the transmitter optical subassembly 811 may be connected to a plurality of different first light speed interfaces. For example, the transmitter optical subassembly 811 is separately connected to the first high-speed interface 821 and the first high-speed interface 822. For descriptions of a connection manner between the receiver optical subassembly 812 and the first high-speed interface, refer to the descriptions of the connection manner between the transmitter optical subassembly 811 and the first high-speed interface. Details are not described. A second connection port of the second circuit board 802 includes a second high-speed interface 831 and a second high-speed interface 832. A quantity of second high-speed interfaces included in the second circuit board 802 is not limited in this embodiment. In this embodiment, an example in which the quantity of first high-speed interfaces included in the first circuit board 801 is equal to the quantity of second high-speed interfaces included in the second circuit board 802 is used. In another example, if one electrical processing module is connected to a plurality of optical-to-electrical conversion modules, a quantity of second high-speed interfaces included in the electrical processing module may be greater than a quantity of first high-speed interfaces included in one connected optical-to-electrical conversion module. When the first circuit board 801 and the second circuit board 802 are separately fastened to a connection board 800, a plurality of first high-speed interfaces included in the first circuit board 801 are sequentially aligned with a plurality of second high-speed interfaces included in the second circuit board 802. For example, the first high-speed interface 821 is aligned with the second high-speed interface 831, and the first high-speed interface 822 is aligned with the second high-speed interface 832. For descriptions of the connection board, refer to the foregoing embodiment. Details are not described. In this embodiment, the first high-speed interface 821 and the second high-speed interface 831 are connected by using a lead, and the first high-speed interface 822 and the second high-speed interface 832 are further connected by using a lead. For descriptions of the lead, refer to the descriptions in the embodiment corresponding to FIG. 3c. Details are not described. The processing unit 821 sends a service electrical signal to the transmitter optical subassembly 811 through the second high-speed interface 831 and the first high-speed interface 821 that are in a connected state. For another example, the receiver optical subassembly 812 sends a service electrical signal to the processing unit 803 through the first high-speed interface 822 and the second high-speed interface 832 that are in a connected state.

In this embodiment, the first connection port further includes a first low-speed interface, and the second connection port includes a second low-speed interface. A quantity of first low-speed interfaces and a quantity of second low-speed interfaces are not limited in this embodiment. Still refer to the example shown in FIG. 8. A first low-speed interface 823 of the first circuit board 801 is aligned with a second low-speed interface 833 of the second circuit board 802, and the first low-speed interface 823 and the second low-speed interface 833 are connected by using a lead. The second low-speed interface 833 is further connected to the processing unit 803. The first low-speed interface 823 is further connected to an optical component driving unit 810 included in the first circuit board 801. The optical component driving unit 810 is further separately connected to the transmitter optical subassembly 811 and the receiver optical subassembly 812. The first low-speed interface 823 and the second low-speed interface 833 that are in a connected state are configured to implement an objective of enabling the processing unit 803 to send an instruction electrical signal to the optical component driving unit 810. For example, the instruction electrical signal may indicate the optical component driving unit 810 to drive the transmitter optical subassembly 811 to emit light. For another example, the instruction electrical signal may indicate a wavelength of an optical signal emitted by the transmitter optical subassembly 811 driven by the optical component driving unit 810. For another example, the instruction electrical signal may indicate the optical component driving unit 810 to drive the transmitter optical subassembly 811 to implement electrical-to-optical conversion. For another example, the instruction electrical signal indicates the optical component driving unit 810 to drive the receiver optical subassembly 812 to receive a service optical signal. For another example, the instruction electrical signal indicates the optical component driving unit 810 to drive the receiver optical subassembly 812 to implement optical-to-electrical conversion and the like.

The first connection port is used as an example. A transmission rate of an electrical signal transmitted by the first high-speed interface is greater than a transmission rate of an electrical signal transmitted by the first low-speed interface. For example, the transmission rate of the electrical signal transmitted by the first high-speed interface is greater than or equal to a rate threshold, and the transmission rate of the electrical signal transmitted by the first low-speed interface is less than the rate threshold. In this embodiment, an example in which the rate threshold is 1 Gbps is used. A value of the rate threshold is not specifically limited.

Optionally, in this embodiment, a first lead is different from a second lead. The first lead is configured to connect the first high-speed interface 821 and the second high-speed interface 831, and the second lead is configured to connect the first low-speed interface 823 and the second low-speed interface 833. That a first lead is different from a second lead specifically means that the first lead and the second lead are made of different materials, and/or a structure of the first lead is different from a structure of the second lead. Because the first lead is different from the second lead, attenuation of an electrical signal in the first lead and the second lead that are different is different. Therefore, transmission rates of the electrical signal in the first lead and the second lead that are different are different. In this embodiment, an example in which attenuation of the electrical signal in the second lead is greater than attenuation of the electrical signal in the first lead is used. In this case, a transmission rate of the electrical signal in the second lead is less than a transmission rate of the electrical signal in the first lead. It may be understood that an electrical signal transmission rate supported by the second lead is less than an electrical signal transmission rate supported by the first lead. When the first lead shown in this embodiment supports a high electrical signal transmission rate, it can be effectively ensured that a service electrical signal is successfully transmitted between the processing unit and the transmitter optical subassembly, and it can be ensured that a service electrical signal is successfully transmitted between the processing unit and the receiver optical subassembly. The second lead is used for an instruction electrical signal with a low transmission rate, and the second lead does not need to support transmission of a high-speed electrical signal at high costs. This effectively reduces costs of the second lead, and further reduces overall costs of the optical module.

A structure of a low-speed interface provided in an embodiment of this application is described with reference to FIG. 8 and FIG. 9. FIG. 9 is an example diagram of a structure of a low-speed interface of the optical module shown in FIG. 8. The first low-speed interface 823 includes at least one pair of power interfaces, and the at least one pair of power interfaces is configured to supply power to the optical component driving unit 810, to ensure that the optical component driving unit 810 drives the transmitter optical subassembly 811 and the receiver optical subassembly 812 to work normally. In the example shown in FIG. 9, the first low-speed interface 823 includes a pair of power interfaces, namely, a voice controlled carrier (voice controlled carrier, VCC) pin and a ground (ground, GND) pin. The first low-speed interface 823 further includes at least one pair of communication buses. The communication bus is configured to transmit the foregoing instruction electrical signal. A type of the communication bus may be an inter-integrated circuit (inter-integrated circuit, IIC) inter-integrated circuit, a serial peripheral interface (serial peripheral interface, SPI), or the like. A specific type of the communication bus is not limited. An example in which the communication bus is an IIC bus is used. The communication interface specifically includes a serial clock (serial clock, SCL) pin and a serial data (serial data, SDA) pin. The first low-speed interface 823 shown in this embodiment may further include an extension pin, to ensure that the first low-speed interface can adapt to a subsequent use requirement of the optical module. A type of the extension pin is not limited in this embodiment. For detailed descriptions of the second low-speed interface 833, refer to the descriptions of the first low-speed interface 823. Details are not described.

In this embodiment, when both the first circuit board 801 and the second circuit board 802 are fastened to the connection board 800, the VCC pin of the first low-speed interface 823 and a VCC pin of the second low-speed interface 833 are aligned and are connected by using a lead, and by analogy, the SCL pin of the first low-speed interface 823 and an SCL pin of the second low-speed interface 833 are aligned and are connected by using a lead. It may be learned that any pin included in the first low-speed interface 823 is connected to one pin included in the second low-speed interface 833 by using a lead.

When the first circuit board 801 includes a plurality of first high-speed interfaces, the first circuit board 801 includes at least one pair of two adjacent first high-speed interfaces. The two adjacent first high-speed interfaces mean that the two first high-speed interfaces are not separated by any first high-speed interface. For example, if the first high-speed interface 821 and the first high-speed interface 822 shown in FIG. 8 are not separated by any first high-speed interface, the first high-speed interface 821 and the first high-speed interface 822 are two adjacent first high-speed interfaces. In the first connection port, the first low-speed interface 823 is located between the first high-speed interface 821 and the first high-speed interface 822 that are adjacent to each other.

In this embodiment, the rate of the electrical signal transmitted by the first high-speed interface is greater than the rate of the electrical signal transmitted by the first low-speed interface. Therefore, when the first low-speed interface 823 is located between the first high-speed interface 821 and the first high-speed interface 822 that are adjacent to each other, the first low-speed interface 823 can perform a block function to some extent, to reduce crosstalk between a high-speed electrical signal transmitted by the first high-speed interface 821 and a high-speed electrical signal transmitted by the first high-speed interface 822. For descriptions of positions of the second high-speed interface and the second low-speed interface included in the second connection port, refer to the descriptions of the first connection port. Details are not described.

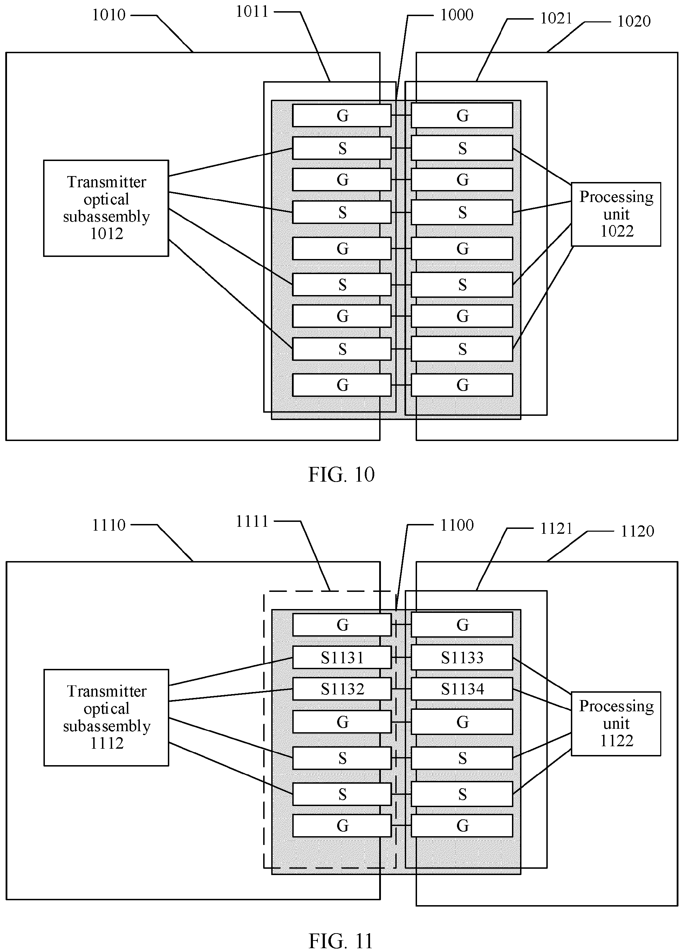

Structures of the first high-speed interface and the second high-speed interface are described with reference to FIG. 10. FIG. 10 is an example diagram of a top-view structure of a second embodiment of an optical module according to an embodiment of this application. The optical module shown in this embodiment includes a first circuit board 1010, a second circuit board 1020, and a connection board 1000. For detailed descriptions, refer to the descriptions in FIG. 3b. Details are not described. A first high-speed interface 1011 included in the first circuit board 1010 is connected to a transmitter optical subassembly 1012, a second high-speed interface 1021 included in the second circuit board 1020 is connected to a processing unit 1022, and the first high-speed interface 1011 and the second high-speed interface 1021 are connected by using a lead. For detailed descriptions, refer to descriptions in FIG. 8 and FIG. 9. Details are not described. For descriptions of the transmitter optical subassembly 1012, refer to the descriptions in FIG. 3c. Details are not described. The transmitter optical subassembly 1012 shown in this embodiment supports multi-channel transmission. For example, the transmitter optical subassembly 1012 supports four-channel transmission. The transmitter optical subassembly 1012 that supports four channels can obtain four service optical signals, the transmitter optical subassembly 1012 separately performs optical-to-electrical conversion on the four service optical signals, to obtain four service electrical signals, and the transmitter optical subassembly 1012 sends the four service electrical signals to the processing unit 1022 through the first high-speed interface 1011 and the second high-speed interface 1021 that are in a connected state. The first high-speed interface 1011 transmits the four service electrical signals. Therefore, the first high-speed interface 1011 includes ground-signal-ground-signal-ground-signal-ground-signal-ground (ground-signal-ground-signal-ground-signal-ground-signal-ground, GSGSGSGSG) pins. It may be understood that in the first high-speed interface 1011, one G pin is included between two adjacent S pins, and each S pin is configured to receive one service electrical signal from the transmitter optical subassembly 1012. For descriptions of pins included in the second high-speed interface 1021, refer to the descriptions of the first high-speed interface 1011. Details are not described. It should be noted that in this embodiment, an example in which the transmitter optical subassembly 1012 supports four-channel transmission is used. A quantity of channels supported by the transmitter optical subassembly is not limited in this embodiment. For descriptions of structures of a first high-speed interface and a second high-speed interface that are connected to a receiver optical subassembly, refer to the descriptions of the first high-speed interface and the second high-speed interface that are connected to the transmitter optical subassembly. Details are not described.

Optional structures of the first high-speed interface and the second high-speed interface are further described with reference to FIG. 11. FIG. 11 is an example diagram of a top-view structure of a third embodiment of an optical module according to an embodiment of this application. For descriptions of a first circuit board 1110, a second circuit board 1120, a connection board 1100, a transmitter optical subassembly 1112, and a processing unit 1122 shown in this embodiment, refer to the descriptions corresponding to FIG. 10. Details are not described. The first circuit board 1110 shown in this embodiment further includes a first high-speed interface 1111 connected to the transmitter optical subassembly 1112. The second circuit board 1120 further includes a second high-speed interface 1121 connected to the processing unit 1122. In this embodiment, an example in which the transmitter optical subassembly 1112 supports two channels is used. For descriptions of the transmitter optical subassembly that supports two channels, refer to the descriptions of the transmitter optical subassembly that supports four channels and that is shown in FIG. 10. Details are not described. A difference between the first high-speed interface 1111 shown in FIG. 11 and the first high-speed interface shown in FIG. 10 lies in that the first high-speed interface 1111 shown in FIG. 11 is a differential interface that can transmit a differential electrical signal. Specifically, an example in which the transmitter optical subassembly 1112 supports two channels is used. The first high-speed interface 1111 includes two pairs of differential pins. A fifth pin (a pin S1131 shown in FIG. 11) and a sixth pin (a pin S1132 shown in FIG. 11) included in the first high-speed interface 1111 are a pair of differential pins. The second high-speed interface 1121 also includes two pairs of differential pins. A seventh pin (a pin S1133 shown in FIG. 11) and an eighth pin (a pin S1134 shown in FIG. 11) included in the second high-speed interface 1121 are a pair of differential pins. The fifth pin and the seventh pin that are in a connected state by using a lead send a third electrical signal from the processing unit 1122 to the transmitter optical subassembly 1112. The sixth pin and the eighth pin that are in a connected state by using a lead send a fourth electrical signal from the processing unit 1122 to the transmitter optical subassembly 1112. The third electrical signal and the fourth electrical signal are a pair of differential electrical signals. The transmitter optical subassembly 1112 loaded with the third electrical signal and the fourth electrical signal performs electrical-to-optical conversion to output a service optical signal. It may be understood that in this embodiment, an example in which the transmitter optical subassembly 1112 supports two channels, the first high-speed interface 1111 includes GSSGSSG pins, and the second high-speed interface 1121 includes GSSGSSG pins. The first high-speed interface 1111 and the second high-speed interface 1121 shown in this embodiment drive the transmitter optical subassembly 1112 by using a differential electrical signal, so that a driving voltage for driving the transmitter optical subassembly 1112 can be reduced, and efficiency of driving the transmitter optical subassembly 1112 is improved. For descriptions of other pairs of differential pins included in the first high-speed interface 1111 and the second high-speed interface 1121, refer to the descriptions of the foregoing differential pins. Details are not described. In this embodiment, an example in which the transmitter optical subassembly supports two-channel transmission is used. A quantity of channels supported by the transmitter optical subassembly 1112 is not limited in this embodiment. For descriptions of structures of a first high-speed interface and a second high-speed interface that are connected to a receiver optical subassembly, refer to the descriptions of the first high-speed interface and the second high-speed interface that are connected to the transmitter optical subassembly 1112. Details are not described.

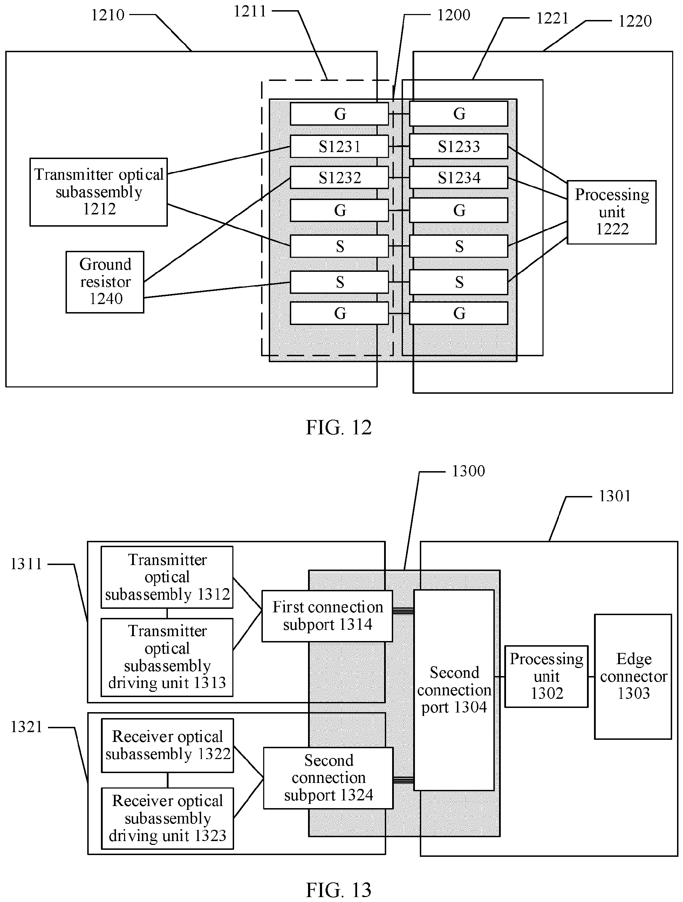

For example, in FIG. 11, the first high-speed interface is a differential interface, and the second high-speed interface is also a differential interface. Therefore, the first high-speed interface and the second high-speed interface that are in a connected state and that are shown in FIG. 11 can send a differential electrical signal from the processing unit to the transmitter optical subassembly. The transmitter optical subassembly supports differential driving, so that the transmitter optical subassembly can perform electrical-to-optical conversion under action of the differential electrical signal. In an embodiment shown in FIG. 12, when the transmitter optical subassembly supports only single-ended driving but does not support differential driving, normal working of the optical module can be ensured without replacing an optical-to-electrical conversion module. FIG. 12 is an example diagram of a top-view structure of a fourth embodiment of an optical module according to an embodiment of this application. For descriptions of a first circuit board 1210, a second circuit board 1220, a connection board 1200, a transmitter optical subassembly 1212, and a processing unit 1222 shown in this embodiment, refer to the descriptions corresponding to FIG. 10. Details are not described. A first high-speed interface 1211 of the first circuit board 1210 is connected to the transmitter optical subassembly 1212. A second high-speed interface 1221 of the second circuit board 1220 is connected to the processing unit 1222. For descriptions of the transmitter optical subassembly 1212 shown in this embodiment, refer to the descriptions in FIG. 3c. Details are not described. In this embodiment, an example in which the transmitter optical subassembly 1212 supports two channels is still used. For descriptions of the transmitter optical subassembly that supports two channels, refer to the descriptions of the transmitter optical subassembly that supports two channels and that is shown in FIG. 11. Details are not described. The first high-speed interface 1211 includes two pairs of differential pins. A first pin (a pin S1231 shown in FIG. 12) and a second pin (a pin S1232 shown in FIG. 12) included in the first high-speed interface 1211 are a pair of differential pins. The second high-speed interface 1221 also includes two pairs of differential pins. A third pin (a pin S1233 shown in FIG. 12) and a fourth pin (a pin S1234 shown in FIG. 12) included in the second high-speed interface 1221 are a pair of differential pins. The first pin and the third pin that are in a connected state by using a lead send a first electrical signal from the processing unit 1222 to the transmitter optical subassembly 1212. The second pin shown in this embodiment is connected to a ground resistor 1240, and the third pin and the fourth pin that are in a connected state by using a lead send a second electrical signal from the processing unit 1222 to the ground resistor 1240. The ground resistor 1240 can terminate transmission of the second electrical signal. The first electrical signal and the second electrical signal are a pair of differential electrical signals. The second electrical signal that is transmitted to the ground resistor 1240 for transmission termination is not sent to the transmitter optical subassembly 1212, so that the second electrical signal is grounded. The transmitter optical subassembly 1212 loaded with the first electrical signal performs electrical-to-optical conversion to output a service optical signal. It may be understood that in this embodiment, an example in which the transmitter optical subassembly 1212 supports two channels, the first high-speed interface 1211 includes GSSGSSG pins, and the second high-speed interface 1221 also includes GSSGSSG pins. In this embodiment, an example in which the transmitter optical subassembly supports two-channel transmission is used. A quantity of channels supported by the transmitter optical subassembly is not limited in this embodiment.

In the embodiment shown in FIG. 12, when the second high-speed interface 1221 of the second circuit board 1220 outputs a pair of differential electrical signals, the transmitter optical subassembly 1212 that supports only single-ended driving can further perform electrical-to-optical conversion on a service electrical signal from the processing unit 1222 to emit a service optical signal. With reference to FIG. 11 and FIG. 12, it may be learned that a second high-speed interface of a same second circuit board can adapt to a transmitter optical subassembly that supports differential driving (the embodiment shown in FIG. 11), and can further adapt to a transmitter optical subassembly that supports single-ended driving (the embodiment shown in FIG. 12). It may be learned that the same second circuit board shown in this embodiment can drive the transmitter optical subassembly that supports single-ended driving, and can further drive the transmitter optical subassembly that supports differential driving, and there is no need to match a different electrical processing module for the transmitter optical subassembly that supports differential driving or single-ended driving, to ensure flexible matching between the optical-to-electrical conversion module and the electrical processing module.

In the foregoing embodiment, an example in which the first circuit board is one circuit board is used. A first circuit board provided in an embodiment shown in FIG. 13 includes two daughter boards. FIG. 13 is an example diagram of a top-view structure of a fifth embodiment of an optical module according to an embodiment of this application. An electrical processing module shown in this embodiment includes a second circuit board 1301, a processing unit 1302, an edge connector 1303, and a second connection port 1304. For detailed descriptions, refer to the descriptions in FIG. 3a to FIG. 3c. Details are not described.

The first circuit board shown in this embodiment includes two daughter boards, namely, a first daughter board 1311 and a second daughter board 1321. The first daughter board 1311 includes a transmitter optical subassembly 1312 and a transmitter optical subassembly driving unit 1313 configured to drive the transmitter optical subassembly 1312. The first circuit board 1311 further includes a first connection subport 1314. A first high-speed interface included in the first connection subport 1314 is connected to the transmitter optical subassembly 1312, a first low-speed interface included in the first connection subport 1314 is connected to the transmitter optical subassembly driving unit 1313, and the first connection subport 1314 is connected to the second connection port 1304. For descriptions of the first high-speed interface and the first low-speed interface included in the first connection subport 1314, refer to FIG. 8 and FIG. 10 to FIG. 12. Details are not described. The first daughter board 1321 includes a receiver optical subassembly 1322 and a receiver optical subassembly driving unit 1323 configured to drive the receiver optical subassembly 1322. The second circuit board 1321 further includes a second connection subport 1324. A first high-speed interface included in the second connection subport 1324 is connected to the receiver optical subassembly 1322, a first low-speed interface included in the second connection subport 1324 is connected to the receiver optical subassembly driving unit 1323, and the second connection subport 1324 is connected to the second connection port 1304. For descriptions of the first high-speed interface and the first low-speed interface included in the second connection subport 1314, refer to FIG. 8, FIG. 10, and FIG. 11. Details are not described.

The first daughter circuit board 1311 and the second circuit board 1301 that are fastened to the connection board 1300 in this embodiment can implement alignment between the first connection subport 1314 and the second connection port 1304. The second daughter circuit board 1321 and the second circuit board 1301 that are fastened to the connection board 1300 can implement alignment between the second connection subport 1324 and the second connection port 1304. It may be understood that the connection board 1300 shown in this embodiment can avoid an offset or an error in relative positions of the first connection subport 1314 and the second connection port 1304, and ensure a successful connection between the first connection subport 1314 and the second connection port 1304 by using a lead. In addition, when the first connection subport 1314 is aligned with the second connection port 1304, a thread length of a lead connected between the first connection subport 1314 and the second connection port 1304 can be effectively reduced, and an insertion loss of an electrical signal transmitted between the first connection subport 1314 and the second connection port 1304 is effectively reduced. Furthermore, the first connection subport 1314 is aligned with the second connection port 1304. Therefore, no operational interference is caused to a lead bonding process, efficiency and accuracy of connecting the first connection subport 1314 and the second connection port 1304 by using the lead are improved, and a case in which the first connection subport 1314 and the second connection port 1304 cannot be connected by using the lead is avoided. For descriptions of beneficial effects of aligning the second connection subport 1324 with the second connection port 1304 by using the connection board 1300, refer to the descriptions of the beneficial effects of aligning the first connection subport 1314 with the second connection port 1304 by using the connection board 1300. Details are not described.

According to the optical module shown in this embodiment, the first daughter board and the second daughter board can be separately processed, to further reduce a manufacturing process of the optical module. In addition, a procedure such as a test can be separately performed on the first daughter board and the second daughter board, to ensure that both the first daughter board and the second daughter board are good products that can work independently and normally. This effectively increases a product yield rate of the optical module. The first daughter board and the second daughter board are separately designed and arranged, to improve flexibility of structures in the optical module. When the first daughter board 1311 included in the optical-to-electrical conversion module is faulty, only the first daughter board 1311 needs to be replaced, and the entire optical-to-electrical conversion module does not need to be replaced. This reduces difficulty in repairing the optical module, a material loss, and costs.

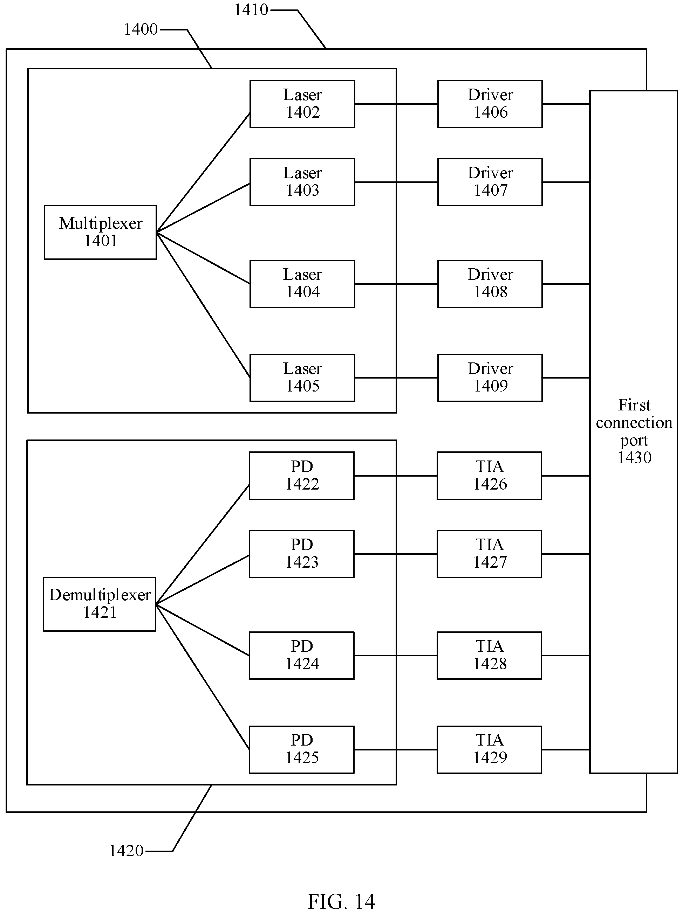

The following describes, by using an example, a structure of an optical-to-electrical conversion module provided in this application. FIG. 14 is an example diagram of a first application scenario of an optical-to-electrical conversion module according to an embodiment of this application. The optical-to-electrical conversion module 1410 shown in this embodiment includes a transmitter optical subassembly 1400 and a receiver optical subassembly 1420. In this embodiment, an example in which the transmitter optical subassembly 1400 supports four channels is used. A quantity of channels supported by the transmitter optical subassembly 1400 is not limited in this embodiment. The transmitter optical subassembly 1400 includes a multiplexer 1401 and four lasers, namely, a laser 1402, a laser 1403, a laser 1404, and a laser 1405, connected to the multiplexer 1401. The optical-to-electrical conversion module further includes four drivers, namely, a driver 1406 connected to the laser 1402, a driver 1407 connected to the laser 1403, a driver 1408 connected to the laser 1404, and a driver 1409 connected to the laser 1405, respectively connected to the four lasers. The four drivers are separately connected to a first connection port 1430.

The first connection port 1430 receives four service electrical signals from an electrical processing module. For descriptions of receiving the service electrical signals by the first connection port 1430, refer to FIG. 8, and FIG. 10 to FIG. 13. Details are not described. The driver 1406 is used as an example. The driver 1406 amplifies power of the service electrical signal from the first connection port 1430, to send an electrical signal obtained after power amplification to the laser 1402. The laser 1402 performs electrical-to-optical conversion on the electrical signal obtained after power amplification to output one service optical signal. The multiplexer 1401 receives four service optical signals from the four lasers, and performs multiplexing to emit a multiplexed service optical signal. Each laser shown in this embodiment is an electro-absorption modulator (electro absorption modulator, EML) having an electrical-to-optical conversion function, a directly modulated laser (directly modulated lasers, DML), a vertical-cavity surface-emitting laser (vertical cavity surface emitting laser, VCSEL), or the like.

In this embodiment, an example in which the four drivers are located on a first circuit board included in an optical processing module is used. The driver 1406 is used as an example. A transmission rate of an electrical signal transmitted by the driver 1406 is high. When the driver 1406 is located on the first circuit board, a distance between the driver 1406 and the laser 1402 is less than a distance that is between the driver 1406 and the laser 1402 and that exists when the driver 1406 is located on a second circuit board. A shorter distance between the driver 1406 and the laser 1402 indicates higher power of the service electrical signal sent by the driver 1406 to the laser 1402 and better signal quality. Therefore, when the driver 1406 is located on the first circuit board, efficiency of performing electrical-to-optical conversion by the laser 1402 can be effectively improved. The driver 1406 is arranged on the first circuit board. This reduces an area and costs of the second circuit board.

In this embodiment, the electrical signal transmitted by the driver 1406 is a high-speed electrical signal. To reduce costs of the first circuit board, a transmission path of the service electrical signal transmitted by the driver 1406 does not need to pass through a trace of the first circuit board, and a first electric-conductor is separately disposed independent of the trace of the first circuit board. An electrical signal transmission rate supported by the first electric-conductor is greater than an electrical signal transmission rate supported by the trace of the first circuit board. The laser 1402 and the first connection port 1430 are separately connected to the driver 1406 by using the first electric-conductor. It may be learned that in this embodiment, a first circuit board that supports a low electrical signal transmission rate may be used, which can also ensure that each driver amplifies an electrical signal sent to the transmitter optical subassembly, to reduce costs of the first circuit board. The driver 1406 shown in this embodiment may alternatively be disposed on the second circuit board, or the driver 1406 is integrated with a processing unit on the second circuit board.

In this embodiment, an example in which the receiver optical subassembly 1420 supports four channels is used. A quantity of channels supported by the receiver optical subassembly 1420 is not limited in this embodiment. The receiver optical subassembly 1420 includes a demultiplexer 1421 and four photodetectors (photo detector, PD), namely, a PD 1422, a PD 1423, a PD 1424, and a PD 1425, connected to the demultiplexer 1421. The optical-to-electrical conversion module further includes four TIAs, namely, a TIA 1426 connected to the PD 1422, a TIA 1427 connected to the PD 1423, a TIA 1428 connected to the PD 1424, and a TIA 1429 connected to the PD 1425, respectively connected to the four PDs. The four TIAs are separately connected to the first connection port 1430. The demultiplexer 1421 receives the multiplexed service optical signal, and demultiplexes the service optical signal to obtain four service optical signals. The demultiplexer 1421 is configured to respectively send the four service optical signals to the four PDs. The PD 1422 is used as an example. The PD 1422 performs optical-to-electrical conversion on a received service optical signal to send a service electrical signal to the TIA 1426. The TIA 1426 amplifies the received service electrical signal to send an amplified service electrical signal to the first connection port 1430.

In this embodiment, an example in which the four TIAs are located on the first circuit board included in the optical processing module is used. A transmission rate of an electrical signal transmitted by the TIA 1426 is high. When the TIA is located on the first circuit board, a distance between the TIA 1426 and the PD 1422 is less than a distance that is between the TIA 1426 and the PD 1422 and that exists when the TIA 1426 is located on the second circuit board. Therefore, when the TIA 1426 is located on the first circuit board, higher power of the service electrical signal received by the TIA 1426 and the service electrical signal sent by the TIA 1426 to the first connection port 1430 indicates better signal quality. This improves efficiency and accuracy of a service carried in the service electrical signal obtained by the electrical processing module. In addition, the TIA 1426 is arranged on the first circuit board. This reduces an area and costs of the second circuit board.

In this embodiment, the electrical signal transmitted by the TIA 1426 is a high-speed electrical signal. To reduce costs of the first circuit board, a transmission path of the service electrical signal transmitted by the TIA 1426 does not need to pass through a trace of the first circuit board, and a second electric-conductor is separately disposed independent of the trace of the first circuit board. An electrical signal transmission rate supported by the second electric-conductor is greater than an electrical signal transmission rate supported by the trace of the first circuit board. The PD 1422 and the first connection port 1430 are separately connected to the TIA 1426 by using the second electric-conductor. It may be learned that in this embodiment, a first circuit board that supports a low electrical signal transmission rate may be used, which can also ensure that each TIA amplifies an electrical signal from the receiver optical subassembly, to reduce costs of the first circuit board. The TIA 1426 shown in this embodiment may alternatively be disposed on the second circuit board, or the TIA 1426 is integrated with the processing unit on the second circuit board.

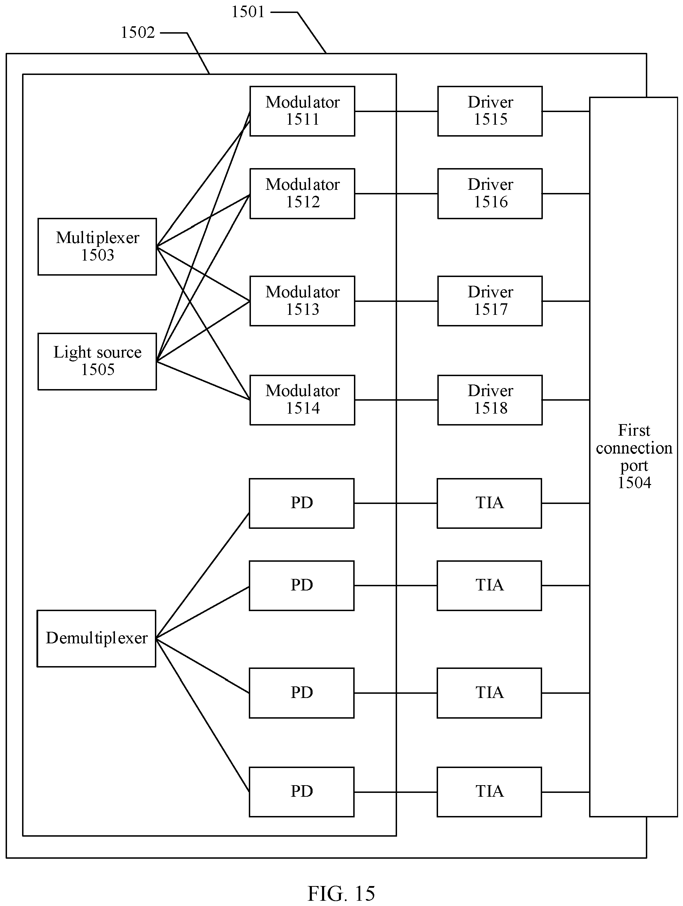

FIG. 15 is an example diagram of a second application scenario of an optical-to-electrical conversion module according to an embodiment of this application. A first circuit board 1501 of the optical-to-electrical conversion module shown in this embodiment further includes a silicon photonic chip 1502. The silicon photonic chip 1502 includes a transmitter optical subassembly and a receiver optical subassembly. In this embodiment, an example in which the transmitter optical subassembly supports four channels is used. A quantity of channels supported by the transmitter optical subassembly is not limited in this embodiment. The transmitter optical subassembly includes a multiplexer 1503 and four modulators, namely, a modulator 1511, a modulator 1512, a modulator 1513, and a modulator 1514, connected to the multiplexer 1503. The first circuit board 1501 further includes four drivers, namely, a driver 1515 connected to the modulator 1511, a driver 1516 connected to the modulator 1512, a driver 1517 connected to the modulator 1513, and a driver 1518 connected to the modulator 1514, respectively connected to the four modulators. The four drivers are separately connected to a first connection port 1504. The modulator 1511 is used as an example. The modulator 1511 may be a microring modulator or a Mach-Zehnder (mach-zehnder, MZ) modulator. The silicon photonic chip further includes a light source 1505. The light source 1505 is configured to respectively send four optical signals to the four modulators. For example, the light source 1505 may be a laser diode (Laser diode). Optionally, in another example, the light source 1505 may not be located on the silicon photonic chip, but is directly located on the first circuit board 1501.

The first connection port 1504 receives four service electrical signals from an electrical processing module. The driver 1515 is used as an example. The driver 1515 amplifies power of the service electrical signal from the first connection port 1504, to send a service electrical signal obtained after power amplification to the modulator 1511. The modulator 1511 modulates the service electrical signal onto an optical signal from the light source 1505 to output one service optical signal. The multiplexer 1503 receives four service optical signals from the four modulators, and performs multiplexing to emit a multiplexed service optical signal.

The four drivers shown in this embodiment are located on the first circuit board. For descriptions of specific beneficial effects, refer to the descriptions corresponding to FIG. 14. Details are not described. The silicon photonic chip 1502 shown in this embodiment further includes the receiver optical subassembly. For descriptions of a structure of the receiver optical subassembly, refer to the descriptions corresponding to FIG. 14. Details are not described. In this embodiment, an example in which the first circuit board includes one silicon photonic chip is used. In another example, the first circuit board may include a plurality of silicon photonic chips. A specific quantity of silicon photonic chips is not limited.

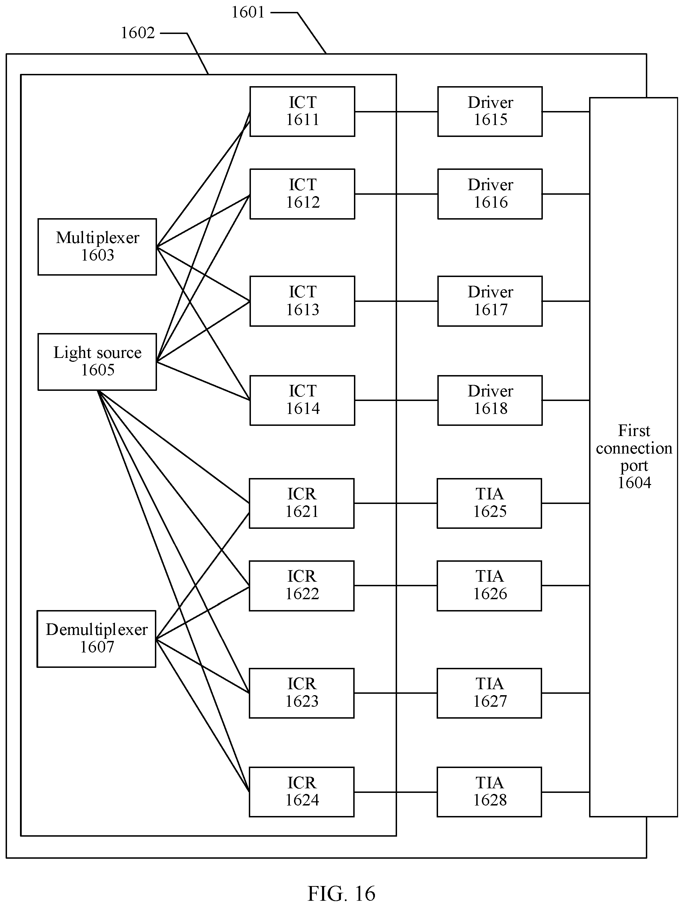

FIG. 16 is an example diagram of a third application scenario of an optical-to-electrical conversion module according to an embodiment of this application. A first circuit board 1601 of the optical-to-electrical conversion module shown in this embodiment further includes a silicon photonic chip 1602. The silicon photonic chip 1602 includes a transmitter optical subassembly and a receiver optical subassembly. In this embodiment, an example in which the transmitter optical subassembly supports four channels is used. A quantity of channels supported by the transmitter optical subassembly is not limited in this embodiment. The transmitter optical subassembly includes a multiplexer 1603 and four integrated coherent transmitters (integrated coherent transmitter, ICT), namely, an ICT 1611, an ICT 1612, an ICT 1613, and an ICT 1614, connected to the multiplexer 1603. The first circuit board 1601 further includes four drivers, namely, a driver 1615 connected to the ICT 1611, a driver 1616 connected to the ICT 1612, a driver 1617 connected to the ICT 1613, and a driver 1618 connected to the ICT 1614, respectively connected to the four ICTs. The four drivers are separately connected to a first connection port 1604. The silicon photonic chip 1602 further includes a light source 1605. For descriptions of the light source 1605, refer to the descriptions corresponding to FIG. 15. Details are not described.

The first connection port 1604 receives four service electrical signals from an electrical processing module. The driver 1615 is used as an example. The driver 1615 amplifies power of the service electrical signal from the first connection port 1604, to send a service electrical signal obtained after power amplification to the ICT. The ICT 1611 modulates the service electrical signal onto an optical signal from the light source 1605 to output one service coherent optical signal. The multiplexer 1603 receives four service coherent optical signals from the four ICTs, and performs multiplexing to emit a multiplexed service coherent optical signal. The four drivers shown in this embodiment are located on the first circuit board. For descriptions of specific beneficial effects, refer to the descriptions corresponding to FIG. 14. Details are not described.

The silicon photonic chip 1602 shown in this embodiment further includes the receiver optical subassembly. In this embodiment, an example in which the receiver optical subassembly supports four channels is used. A quantity of channels supported by the receiver optical subassembly is not limited in this embodiment. The receiver optical subassembly includes a demultiplexer 1607 and four integrated coherent receivers (integrated coherent receiver, ICR), namely, an ICR 1621, an ICR 1622, an ICR 1623, and an ICR 1624, connected to the demultiplexer 1607. The first circuit board further includes four TIAs, namely, a TIA 1625 connected to the ICR 1621, a TIA 1626 connected to the ICR 1622, a TIA 1627 connected to the ICR 1623, and a TIA 1628 connected to the ICR 1624, respectively connected to the four ICRs. The four TIAs are separately connected to the first connection port 1604. The demultiplexer 1607 receives the multiplexed service coherent optical signal, and demultiplexes the multiplexed service coherent optical signal to obtain four service coherent optical signals. The demultiplexer 1607 is configured to respectively send the four service coherent optical signals to the four ICRs. The ICR 1621 is used as an example. The ICR 1621 performs coherent coupling on the received service coherent optical signal and a local-frequency optical signal from the light source 1605, performs optical-to-electrical conversion to output a service electrical signal, and sends the service electrical signal to the TIA 1625. The TIA 1625 amplifies the received service electrical signal, to send an amplified service electrical signal to the first connection port 1604. In this embodiment, an example in which the ICT and the ICR share the light source 1605 is used, to reduce costs of the optical-to-electrical conversion module. In another example, the ICT and the ICR may respectively use different light sources.

In this embodiment, an example in which the four TIAs are located on the first circuit board included in an optical processing module is used. For descriptions of specific beneficial effects, refer to the descriptions in the embodiment corresponding to FIG. 14. Details are not described. The optical conversion module shown in this embodiment can implement coherent optical communication. This effectively improves sensitivity, a communication capacity, and a communication distance of the optical-to-electrical conversion module.

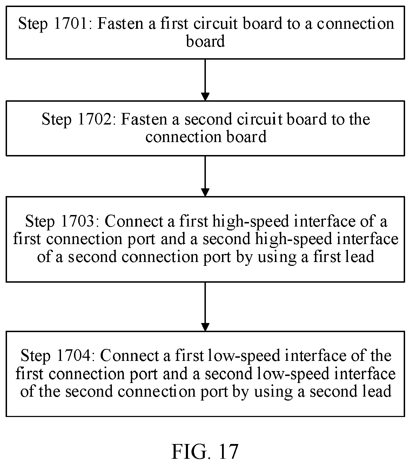

An embodiment further provides an assembly method used to assemble an optical module. FIG. 17 is a flowchart of steps of an assembly method according to an embodiment of this application.

Step 1701: Fasten a first circuit board to a connection board.

In this embodiment, the first circuit board may be fastened to the connection board by using an assembly device. For example, the first circuit board is fastened to the connection board by using a mechanical arm. Specifically, the first circuit board is fastened to a first region by using a first positioning member in the first region of the connection board. For descriptions of a specific fastening manner, refer to the descriptions in FIG. 5a and FIG. 5b, or refer to the descriptions in FIG. 6a and FIG. 6b. Details are not described.

Step 1702: Fasten a second circuit board to the connection board.

A time sequence of performing step 1701 and step 1702 is not limited in this embodiment. For example, step 1701 may be performed before step 1702. For another example, step 1702 is performed before step 1701. For another example, step 1701 and step 1702 are simultaneously performed. For description of an execution body for performing step 1702, refer to the descriptions in step 1701. Details are not described.

Specifically, the second circuit board is fastened to a second region by using a second positioning member in the second region of the connection board. For descriptions of a process of fastening the second circuit board to the connection board in this embodiment, refer to the descriptions in FIG. 5c or FIG. 6c. Details are not described. It may be learned from the foregoing embodiment that a first connection port of the first circuit board fastened to the connection board is aligned with a second connection port of the second circuit board.

Step 1703: Connect a first high-speed interface of the first connection port and a second high-speed interface of the second connection port by using a first lead.

For detailed descriptions of this step, refer to the descriptions corresponding to FIG. 8. Details are not described.

Step 1704: Connect a first low-speed interface of the first connection port and a second low-speed interface of the second connection port by using a second lead.

A time sequence of performing step 1703 and step 1704 shown in this embodiment is not limited. For example, step 1703 may be performed before step 1704. For another example, step 1704 is performed before step 1703. For another example, step 1703 and step 1704 are simultaneously performed.

For detailed descriptions of this step, refer to the descriptions corresponding to FIG. 8 and FIG. 9. Details are not described.

In this embodiment, when both the first circuit board and the second circuit board are fastened to the connection board, a test may be directly performed. If a normal result is obtained by performing a test, the connection board to which the first circuit board and the second circuit board are fastened is packaged into a housing of an optical module. Then, the packaged optical module may be tested again to ensure normal use of the packaged optical module. A test manner is not limited in this embodiment, provided that it is ensured that the optical module that passes the test can be used normally. For example, the test may include a test on optical power of the optical module, a test performed by using an optical spectrometer, a test performed by using an eye pattern meter, or a test performed by using a bit error rate tester.

The foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of the present invention.

## Claims

1. An optical module, wherein the optical module comprises a first circuit board, a second circuit board, and a connection board, the first circuit board comprises a transmitter optical subassembly and a receiver optical subassembly, the second circuit board comprises a processing unit, the first circuit board further comprises a first connection port, the second circuit board further comprises a second connection port, the transmitter optical subassembly and the receiver optical subassembly are separately connected to the first connection port, and the processing unit is connected to the second connection port;
the first circuit board and the second circuit board are fastened to the connection board, and the connection board is configured to align the first connection port with the second connection port; and
the first connection port and the second connection port are connected by using leads.

2. The optical module according to claim 1, wherein that the connection board is configured to align the first connection port with the second connection port comprises:
the first connection port comprises a first high-speed interface, the second connection port comprises a second high-speed interface, the first high-speed interface is any high-speed interface comprised in the first connection port, the second high-speed interface is a high-speed interface comprised in the second connection port, and the connection board is configured to align the first high-speed interface with the second high-speed interface; and
the first connection port comprises a first low-speed interface, the second connection port comprises a second low-speed interface, the first low-speed interface is any low-speed interface comprised in the first connection port, the second low-speed interface is a low-speed interface comprised in the second connection port, and the connection board is configured to align the first low-speed interface with the second low-speed interface.

3. The optical module according to claim 2, wherein the leads comprise a first lead and a second lead, and that the first connection port and the second connection port are connected by using leads comprises:
the first high-speed interface and the second high-speed interface are connected by using the first lead, and the first low-speed interface and the second low-speed interface are connected by using the second lead.

4. The optical module according to claim 3, wherein an electrical signal transmission rate supported by the first lead is greater than an electrical signal transmission rate supported by the second lead.

5. The optical module according to any one of claims 2 to 4, wherein in the first connection port, the first low-speed interface is located between two adjacent first high-speed interfaces, and in the second connection port, the second low-speed interface is located between two adjacent second high-speed interfaces.

6. The optical module according to any one of claims 2 to 5, wherein the first high-speed interface comprises a first pin and a second pin, the first pin is connected to the transmitter optical subassembly, and the second pin is grounded;
the second high-speed interface comprises a third pin and a fourth pin, the third pin is separately connected to the first pin and the processing unit, and the fourth pin is separately connected to the second pin and the processing unit; and
the third pin is configured to receive a first electrical signal from the processing unit, and the fourth pin is configured to receive a second electrical signal from the processing unit, wherein the first electrical signal and the second electrical signal are a pair of differential electrical signals.

7. The optical module according to any one of claims 2 to 5, wherein the first high-speed interface comprises a fifth pin and a sixth pin, and both the fifth pin and the sixth pin are connected to the transmitter optical subassembly;
the second high-speed interface comprises a seventh pin and an eighth pin, the seventh pin is separately connected to the fifth pin and the processing unit, and the eighth pin is separately connected to the sixth pin and the processing unit; and
the seventh pin is configured to receive a third electrical signal from the processing unit, and the eighth pin is configured to receive a fourth electrical signal from the processing unit, wherein the third electrical signal and the fourth electrical signal are a pair of differential electrical signals.

8. The optical module according to any one of claims 1 to 7, wherein a board material of the first circuit board is different from a board material of the second circuit board, and an electrical signal transmission rate supported by the first circuit board is less than an electrical signal transmission rate supported by the second circuit board.

9. The optical module according to any one of claims 1 to 8, wherein that the first circuit board and the second circuit board are fastened to the connection board comprises:
two sides of a same surface of the connection board respectively comprise a first region and a second region, the first region comprises a first positioning member, the first positioning member is configured to fasten the first circuit board to the first region, the second region comprises a second positioning member, and the second positioning member is configured to fasten the second circuit board to the second region.

10. The optical module according to any one of claims 1 to 9, wherein the first circuit board comprises a first daughter board and a second daughter board, the first connection port comprises a first connection subport and a second connection subport, the first daughter board comprises the transmitter optical subassembly and the first connection subport, the second daughter board comprises the receiver optical subassembly and the second connection subport, the transmitter optical subassembly is connected to the first connection subport, and the receiver optical subassembly is connected to the second connection subport;
the connection board is configured to align the first connection subport with the second connection port, and the connection board is further configured to align the second connection subport with the second connection port; and
the first connection subport is connected to the second connection port by using a lead, and the second connection subport is connected to the second connection port by using a lead.

11. The optical module according to any one of claims 1 to 10, wherein the first circuit board further comprises a driver and/or an amplifier, the driver is separately connected to the transmitter optical subassembly and the first connection port, and the amplifier is separately connected to the receiver optical subassembly and the first connection port.

12. The optical module according to claim 11, wherein the transmitter optical subassembly and the first connection port are separately connected to the driver by using a first electric-conductor, and an electrical signal transmission rate supported by the first electric-conductor is greater than the electrical signal transmission rate supported by the first circuit board; and
the receiver optical subassembly and the first connection port are separately connected to the amplifier by using a second electric-conductor, and an electrical signal transmission rate supported by the second electric-conductor is greater than the electrical signal transmission rate supported by the first circuit board.

13. An optical-to-electrical conversion module, wherein the optical-to-electrical conversion module comprises a first circuit board, the first circuit board comprises a transmitter optical subassembly and a receiver optical subassembly, the first circuit board further comprises a first connection port, and the transmitter optical subassembly and the receiver optical subassembly are separately connected to the first connection port;
the first circuit board is configured to be fastened to a connection board, the connection board is further configured to fasten a second circuit board, and the first connection port is aligned with a second connection port comprised in the second circuit board by using the connection board; and
the first connection port and the second connection port are connected by using leads.

14. The optical-to-electrical conversion module according to claim 13, wherein the first connection port comprises a first high-speed interface, the first high-speed interface is any high-speed interface comprised in the first connection port, and the first high-speed interface is aligned with a second high-speed interface comprised in the second connection port by using the connection board; and
the first connection port comprises a first low-speed interface, the first low-speed interface is any low-speed interface comprised in the first connection port, and the first low-speed interface is aligned with a second low-speed interface comprised in the second connection port by using the connection board.

15. The optical-to-electrical conversion module according to claim 14, wherein the first high-speed interface and the second high-speed interface are connected by using the first lead, and the first low-speed interface and the second low-speed interface are connected by using the second lead.

16. The optical-to-electrical conversion module according to claim 15, wherein an electrical signal transmission rate supported by the first lead is greater than an electrical signal transmission rate supported by the second lead.

17. The optical-to-electrical conversion module according to any one of claims 14 to 16, wherein in the first connection port, the first low-speed interface is located between two adjacent first high-speed interfaces.

18. The optical-to-electrical conversion module according to any one of claims 14 to 17, wherein the first high-speed interface comprises a first pin and a second pin, the first pin is connected to the transmitter optical subassembly, and the second pin is grounded; and
the first pin is configured to receive a first electrical signal from the second high-speed interface, and the second pin is configured to receive a second electrical signal from the second high-speed interface, wherein the first electrical signal and the second electrical signal are a pair of differential electrical signals.

19. The optical-to-electrical conversion module according to any one of claims 13 to 18, wherein the first circuit board comprises a first daughter board and a second daughter board, the first connection port comprises a first connection subport and a second connection subport, the first daughter board comprises the transmitter optical subassembly and the first connection subport, the second daughter board comprises the receiver optical subassembly and the second connection subport, the transmitter optical subassembly is connected to the first connection subport, and the receiver optical subassembly is connected to the second connection subport;
the first connection subport is aligned with the second connection port by using the connection board, and the second connection subport is aligned with the second connection port by using the connection board; and
the first connection subport is connected to the second connection port by using a lead, and the second connection subport is connected to the second connection port by using a lead.

20. The optical-to-electrical conversion module according to any one of claims 13 to 19, wherein the first circuit board further comprises a driver and/or an amplifier, the driver is separately connected to the transmitter optical subassembly and the first connection port, and the amplifier is separately connected to the receiver optical subassembly and the first connection port.

21. The optical-to-electrical conversion module according to claim 20, wherein the transmitter optical subassembly and the first connection port are separately connected to the driver by using a first electric-conductor, and an electrical signal transmission rate supported by the first electric-conductor is greater than an electrical signal transmission rate supported by the first circuit board; and
the receiver optical subassembly and the first connection port are separately connected to the amplifier by using a second electric-conductor, and an electrical signal transmission rate supported by the second electric-conductor is greater than the electrical signal transmission rate supported by the first circuit board.

22. An electrical processing module, wherein the electrical processing module comprises a second circuit board, the second circuit board comprises a processing unit, the second circuit board further comprises a second connection port, and the processing unit is connected to the second connection port;
the second circuit board is configured to be fastened to a connection board, the connection board is further configured to fasten a first circuit board, and the second connection port is aligned with a first connection port comprised in the first circuit board by using the connection board; and
the first connection port and the second connection port are connected by using leads.

23. The electrical processing module according to claim 22, wherein the second connection port comprises a second high-speed interface, the second high-speed interface is a high-speed interface comprised in the second connection port, and the second high-speed interface is aligned with a first high-speed interface comprised in the first connection port by using the connection board; and
the second connection port comprises a second low-speed interface, the second low-speed interface is a low-speed interface comprised in the second connection port, and the second low-speed interface is aligned with a first low-speed interface comprised in the first connection port by using the connection board.

24. The electrical processing module according to claim 23, wherein the first high-speed interface and the second high-speed interface are connected by using the first lead, and the first low-speed interface and the second low-speed interface are connected by using the second lead.

25. The electrical processing module according to claim 24, wherein an electrical signal transmission rate supported by the first lead is greater than an electrical signal transmission rate supported by the second lead.

26. The electrical processing module according to any one of claims 23 to 25, wherein in the second connection port, the second low-speed interface is located between two adjacent second high-speed interfaces.

27. An assembly method, wherein the assembly method is used to assemble an optical module, the optical module comprises a first circuit board, a second circuit board, and a connection board, and the method comprises:
fastening the first circuit board to the connection board;
fastening the second circuit board to the connection board, wherein a first connection port of the first circuit board is aligned with a second connection port of the second circuit board by using the connection board; and
connecting the first connection port and the second connection port by using leads.

28. The assembly method according to claim 27, wherein the connecting the first connection port and the second connection port by using leads comprises:
connecting a first high-speed interface of the first connection port and a second high-speed interface of the second connection port by using a first lead, wherein the first high-speed interface is any high-speed interface comprised in the first connection port, the second high-speed interface is a high-speed interface comprised in the second connection port, and the first high-speed interface is aligned with the second high-speed interface by using the connection board; and
connecting a first low-speed interface of the first connection port and a second low-speed interface of the second connection port by using a second lead, wherein the first low-speed interface is any low-speed interface comprised in the first connection port, the second low-speed interface is a low-speed interface comprised in the second connection port, and the first low-speed interface is aligned with the second low-speed interface by using the connection board.

29. The assembly method according to claim 27 or 28, wherein two sides of a same surface of the connection board respectively comprise a first region and a second region, the first region comprises a first positioning member, the second region comprises a second positioning member, and the fastening the first circuit board to the connection board comprises:
fastening the first circuit board to the first region by using the first positioning member; and
the fastening the second circuit board to the connection board comprises:
fastening the second circuit board to the second region by using the second positioning member.

30. An optical communication device, wherein the optical communication device comprises a communication board, and the optical communication device further comprises at least one optical module connected to the communication board, wherein the optical module is described according to any one of claims 1 to 12.
